# EUROPEAN PATENT APPLICATION

(11) **EP 4 819 381 A1**
(43) Date of publication of application: **07.10.2026**
(21) Application number: 24913585.6
(22) Date of filing: 09.12.2024
(51) Int. Cl.: H01Q 1/24, H01Q 21/06, H01Q 1/38

(54) **WIRELESS MODULE AND ELECTRONIC DEVICE COMPRISING SAME**

(30) Priority: 29.12.2023 KR 20230197928
(71) Applicant: Samsung Electronics Co., Ltd., Suwon-si, Gyeonggi-do 16677 (KR)
(72) Inventor: BAEK, Kwanghyun, Suwon-si Gyeonggi-do 16677 (KR); KIM, Youngsub, Suwon-si Gyeonggi-do 16677 (KR); KIM, Jinhoon, Suwon-si Gyeonggi-do 16677 (KR); PARK, Chunmyung, Suwon-si Gyeonggi-do 16677 (KR); YEOM, Hyunho, Suwon-si Gyeonggi-do 16677 (KR); LEE, Jungyub, Suwon-si Gyeonggi-do 16677 (KR); JUNG, Sohyeon, Suwon-si Gyeonggi-do 16677 (KR); HA, Dohyuk, Suwon-si Gyeonggi-do 16677 (KR)
(74) Representative: Gulde & Partner
(86) International application number: PCT/KR2024/020109
(87) International publication number: WO 2025/143642

(57) **Abstract**

Provided is a wireless module of an electronic device for performing communication with a terminal. The wireless module may include: a first substrate; a radio frequency (RF) processing circuit electrically connected to the first substrate; a second substrate including a plurality of layers; a plurality of radiators which are arranged in at least one layer among the layers of the second substrate; and a grid array including a plurality of solder elements coupled to a first side of the first substrate and a first side of the second substrate. The first side of the second substrate may include a connection region to which the plurality of solder elements are coupled and at least one corner region to which no solder element is coupled. The second substrate may include a copper portion arranged on a layer which differs from the at least one layer among the layers of the second substrate and corresponds to the first side. The copper portion may include a portion partially formed in the at least one corner region.

## Description

### [Technical Field]

The present disclosure relates to a wireless module and an electronic device including the same.

### [Background Art]

As one of technologies for mitigating radio wave path loss and increasing a transmission distance of a radio wave, a beamforming technology is being used. In general, beamforming concentrates a reach area of a radio wave by using a plurality of antennas or increases directivity of reception sensitivity for a specific direction. A product equipped with a plurality of antennas is being developed to improve communication performance, and it is expected that equipment having the significantly larger number of antennas will be increasingly used.

The above-described information may be provided as a related art for the purpose of helping understanding of the present disclosure. No argument or decision is made as to whether any of the above descriptions may be applied as a prior art related to the present disclosure.

### [Disclosure]

### [Technical Solution]

In embodiments, a radio module of an electronic device to perform communication with a terminal is provided. The radio module may comprise a first board, radio frequency (RF) processing circuitry electrically connected to the first board, a second board including a plurality of layers, a plurality of radiators disposed in at least one first layer among the layers of the second board, and a grid array including a plurality of solder elements coupled to a first side of the first board and a first side of the second board. The first side of the second board may include a connection area where the plurality of solder elements are coupled and at least one corner area where any solder element is not coupled. The second board may include a copper portion disposed in at least one second layer different from the at least one first layer among the layers of the second board. The copper portion may include a portion partially formed within the at least one corner area.

In embodiments, an electronic device to perform communication with a terminal is provided. The electronic device may comprise a first board, radio frequency (RF) processing circuitry electrically connected to the first board, a plurality of second boards, a plurality of radiators disposed in at least one first layer among layers of each of the second boards, and a grid array including a plurality of solder elements coupled to a first side of the first board and a first side of each of the plurality of second boards. The first side of each of the plurality of second boards may include a connection area where the plurality of solder elements are coupled and at least one corner area where any solder element is not coupled. Each of the plurality of second boards may include a copper portion disposed in at least one second layer different from the at least one first layer among the layers. The copper portion may include a portion partially formed within the at least one corner area.

In embodiments, a radio module of an electronic device to perform communication with a terminal is provided. The radio module may comprise a first board, radio frequency (RF) processing circuitry electrically connected to the first board, a second board including a plurality of layers, a plurality of radiators disposed in at least one layer among the layers of the second board, and a grid array including a plurality of solder elements coupled to a first side of the first board and a first side of the second board. The first side of the second board may include a connection area where the plurality of solder elements are coupled and at least one corner area where any solder element is not coupled. The second board may include a copper portion disposed in a layer, which corresponds to the first side of the second board and is different from the at least one layer, among the layers of the second board. The copper portion may include a portion partially formed within the at least one corner area.

In embodiments, an electronic device to perform communication with a terminal is provided. The electronic device may comprise a first board, a plurality of radio frequency (RF) processing circuitries electrically connected to the first board, a plurality of second boards, a plurality of radiators disposed in at least one layer among layers of each of the second boards, and a grid array including a plurality of solder elements coupled to a first side of the first board and a first side of each of the plurality of second boards. The first side of each of the plurality of second boards may include a connection area where the plurality of solder elements are coupled and at least one corner area where any solder element is not coupled. Each of the plurality of second boards may include a copper portion disposed in a layer, which corresponds to the first side and is different from the at least one layer, among the layers. The copper portion may include a portion partially formed within the at least one corner area.

### [Description of the Drawings]

FIG. 1 illustrates an example of a wireless communication system.
FIGS. 2A and 2B illustrate an example of components of an electronic device.
FIGS. 3A and 3B illustrate an example of a functional configuration of an electronic device.
FIG. 4 illustrates an example of a radio module of an electronic device.
FIG. 5 illustrates an example of a radio module including a surface mounted device (SMD) type antenna.
FIG. 6 illustrates an example of a second board (substrate) where an antenna is disposed.
FIG. 7 illustrates an example of a first surface of a second board where a ball grid array is disposed.
FIGS. 8A and 8B illustrate examples of a disposition of balls of a ball grid array.
FIGS. 9A and 9B illustrate other examples of a disposition of balls of a ball grid array.
FIGS. 10A, 10B, and 10C illustrate examples of a signal line and a ground line of a ball grid array.
FIGS. 11A and 11B illustrate examples of a copper portion of a second board.
FIGS. 12A and 12B illustrate other examples of a copper portion of a second board.
FIGS. 13A and 13B illustrate examples of a radio module including an SMD type antenna.
FIG. 14 illustrates an example of components of an electronic device including a radio module.

In association with description of the drawings, the same or similar reference numerals may be used for the same or similar components.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a part of an electronic device (e.g., a substrate, a board, a printed circuit board (PCB), a flexible PCB (FPCB), a module, an antenna, an antenna element, circuitry, a processor, a chip, a component, or a device), a term referring to a shape of a part (e.g., a structure, a construct, a support portion, a contact portion, or a protrusion portion), a term referring to a connection portion between structures (e.g., a connection portion, a contact portion, a support portion, a contact structure, a conductive member, or an assembly), a term referring to circuitry (e.g., a PCB, an FPCB, a signal line, a feedline (feeding line), a data line, an RF signal line, an antenna line, an RF path, an RF module, RF circuitry, RF processing circuitry, a splitter, a divider, a coupler, or a combiner), and the like used in the following description are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

The present disclosure describes various embodiments by using terms used in some communication standards (e.g., 3rd Generation Partnership Project (3GPP), European Telecommunications Standards Institute (ETSI), extensible radio access network (xRAN), and open-radio access network (O-RAN)), but this is merely an example for description. Various embodiments of the present disclosure may be easily modified and applied to another communication system.

Hereinafter, the present disclosure relates to, in a radio module (e.g., an RU module or a radio module) including a surface mounted device (SMD) type antenna, a technology for attaching a board where an antenna is disposed (hereinafter, an antenna board) to a main board of the radio module. The antenna board may be coupled to the main board through a solder array (e.g., a ball grid array (BGA), a land grid array (LGA), or a pin grid array (PGA)). For example, a ball grid array may be disposed between the antenna board and the main board. Due to a high-temperature process, bending or warpage of the antenna board may occur. The radio module according to embodiments of the present disclosure may reduce an effect due to bending or warpage of the antenna board through solder elements (e.g., balls) disposed only in another area excluding at least one corner area (e.g., an area including a corner of a rectangle) in a specified shape (e.g., a rectangular shape, a square shape, or a polygon). In addition, based on a ground layer, the antenna board according to embodiments of the present disclosure may reduce an effect due to bending or warpage of the antenna board through a copper portion (e.g., a copper portion partially formed rather than an entire layer) formed across lower layers different from upper layers where an antenna is positioned.

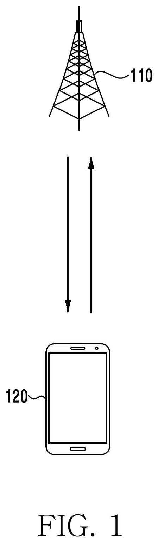

FIG. 1 illustrates an example of a wireless communication system.

FIG. 1 exemplifies a base station 110 and a terminal 120 as a portion of nodes using a wireless channel in a wireless communication system. Although FIG. 1 illustrates only one base station, another base station the same as or similar to the base station 110 may be further included.

The base station 110 is a network infrastructure that provides wireless access to the terminal 120. The base station 110 has coverage defined as a certain geographic area based on a distance at which a signal may be transmitted. In addition to a base station, the base station 110 may be referred to as an 'access point (AP),' an 'eNodeB (eNB),' a '5th generation node,' a '5G NodeB (NB),' a 'wireless point,' a 'transmission/reception point (TRP),' an 'access unit,' a 'distributed unit (DU),' a 'transmission/reception point (TRP),' a 'radio unit (RU),' a remote radio head (RRH), communication equipment, a communication device, wireless communication equipment, a wireless communication device, an electronic device, or another term having a technical meaning equivalent thereto. The base station 110 may transmit a downlink signal or receive an uplink signal.

The terminal 120, which is a device used by a user, performs communication with the base station 110 through a wireless channel. In some cases, the terminal 120 may be operated without involvement of the user. That is, the terminal 120, which is a device that performs machine type communication (MTC), may not be carried by the user. In addition to a terminal, the terminal 120 may be referred to as 'user equipment (UE),' a 'mobile station,' a 'subscriber station,' 'customer premises equipment (CPE),' a 'remote terminal,' a 'wireless terminal,' an 'electronic device,' a 'terminal for a vehicle,' a 'user device,' communication equipment, a communication device, wireless communication equipment, a wireless communication device, or another term having a technical meaning equivalent thereto.

As one of technologies for mitigating radio wave path loss and increasing a transmission distance of a radio wave, a beamforming technology is being used. In order to form beamforming coverage instead of forming a signal in an isotropic pattern by using a single antenna, communication equipment may include a plurality of antennas. Hereinafter, an antenna array including a plurality of antennas (or which may be referred to as an array antenna) is described. The base station 110 or the terminal 120 may include an antenna array. Each antenna included in the antenna array may be referred to as an array element or an antenna element. Hereinafter, in the present disclosure, the antenna array is illustrated as a two-dimensional planar array, but this is merely an embodiment and does not limit other embodiments of the present disclosure. The antenna array may be configured in various forms, such as a linear array, a multilayer array, or the like. The antenna array may be referred to as a massive antenna array.

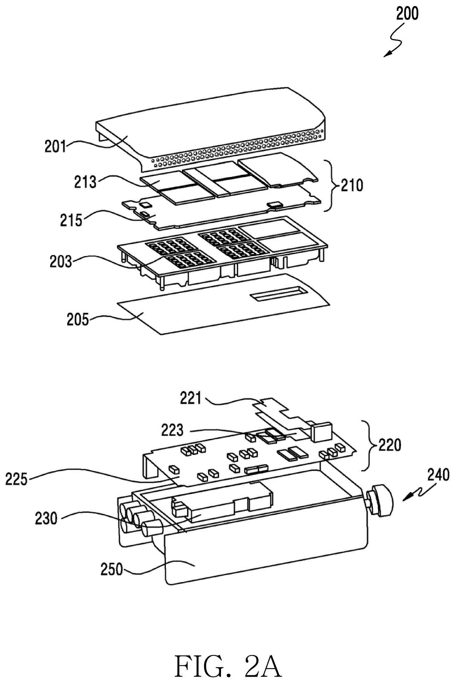

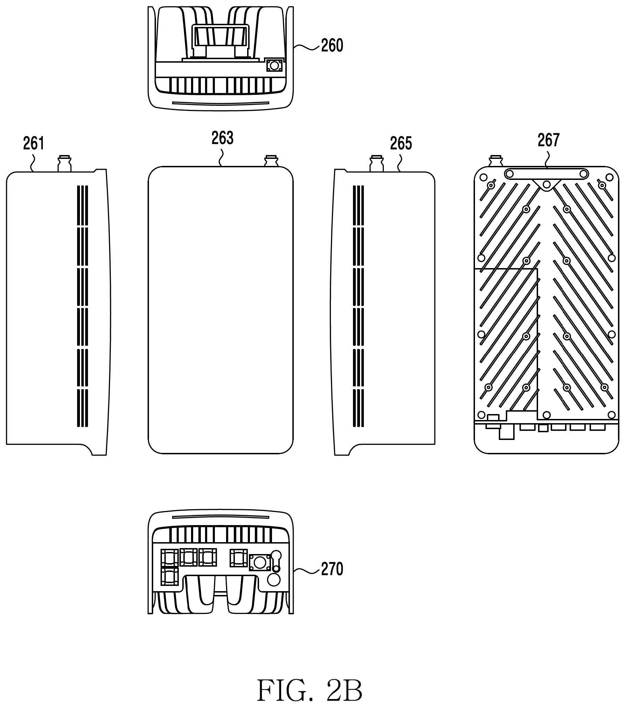

FIGS. 2A and 2B illustrate an example of components of an electronic device.

FIG. 2A may represent internal components configuring an electronic device 200. FIG. 2B represents six surfaces (e.g., an upper surface, a lower surface, a left surface, a right surface, and a front surface) of the electronic device 200. The electronic device 200 exemplifies the base station 110 of FIG. 1, but descriptions of the electronic device 200 described below may be applied to the terminal 120.

Referring to FIG. 2A, the electronic device 200 may include a radome cover 201, a radio unit (RU) housing 203, a digital unit (DU) cover 205, and an RU module 210. The RU module 210 may include an antenna module 213 and an RU board 215. RF components for the antenna module 213 may be disposed on the RU board 215. The RF components may include at least one of a connector for providing power, a DC/DC converter, a field programmable gate array (FPGA), a low dropout (LDO) regulator, or a local oscillator (LO).

A board on which the antenna module 213 is disposed may be referred to as an antenna board, an antenna substrate, a radiation substrate, a radiation board, an RF board, or an RF substrate. For example, the board on which the antenna module 213 is disposed may be a printed circuit board (PCB). In addition, for example, the board on which the antenna module 213 is disposed may be a flexible PCB (FPCB). The RU board 215 may be referred to as a main board, a main substrate, a power board, a mother board, a mother substrate, a package board, or a filter board. The RU module 210 may be referred to as a baseband unit (BBU) or baseband equipment. In order to refer to an integrated base station on which the RU module 210 is mounted, terms such as an access unit (AU), a compact macro, or a link cell may be used instead for an operation and a function of the RU module 210.

The electronic device 200 may include a DU module 220. The DU module 220 may include an interface board 221, a modem board 223, and a CPU board 225. The electronic device 200 may include a power module 230, a GPS 240, and a DU housing 250. The DU module 220 may be referred to as a radio unit (RU) or a remote radio head (RRH).

Referring to FIG. 2B, a drawing 260 represents a view of the electronic device 200 viewed from above. A drawing 261, a drawing 263, a drawing 265, and a drawing 267 represent views of the electronic device 200 viewed from the left, the front, the right, and the rear, respectively. A drawing 270 represents a drawing of viewing the electronic device 200 from below.

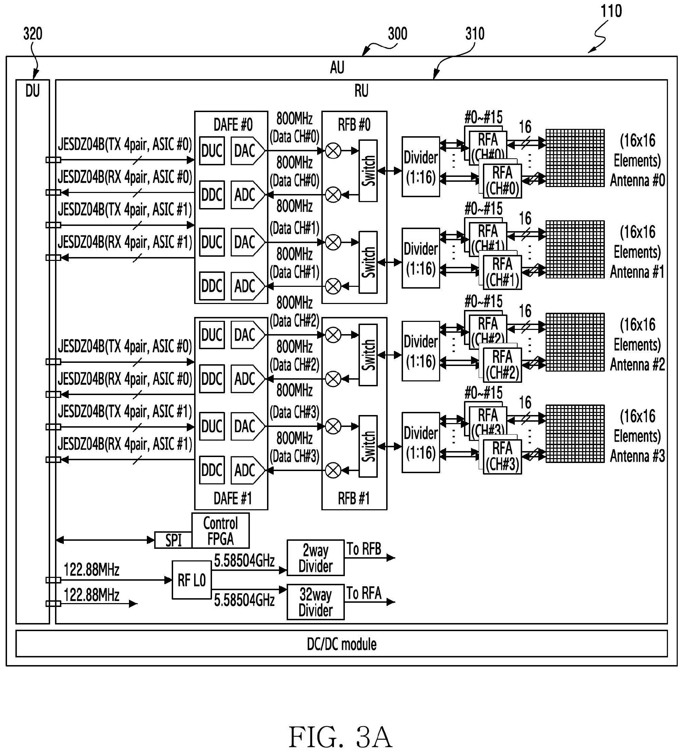

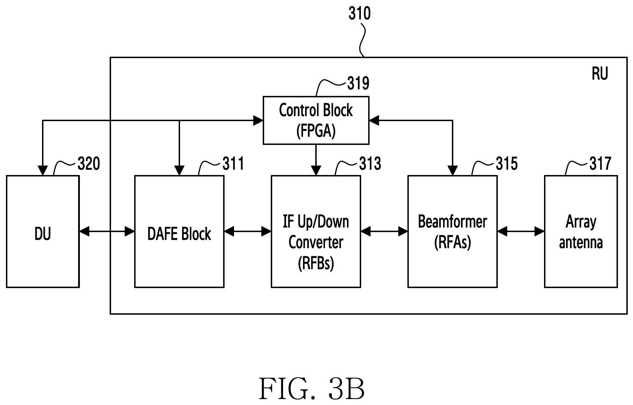

FIGS. 3A and 3B illustrate an example of a functional configuration of an electronic device (e.g., the base station 110 or the terminal 120 of FIG. 1, or the electronic device 200 of FIG. 2A). The electronic device may include an access unit (AU) 300. The access unit 300 may include an RU 310, a DU 320, and a direct current (DC)/DC module. For example, the RU 310 may mean an assembly on which antennas and RF components are mounted. For example, the DU 320 may be configured to process a digital radio signal, and may be configured to encrypt a digital radio signal to be transmitted to the RU 310, or decrypt a digital radio signal delivered from the RU 310. The DU 320 may be configured to perform communication with an upper node (e.g., a centralized unit (CU)) or a core network (e.g., 5GC or EPC) by processing packet data.

Referring to FIG. 3A, the RU 310 may include a plurality of antenna elements. The RU 310 may include one or more array antennas. For example, an array antenna may be configured as a planar antenna array. The array antenna may correspond to one stream. The array antenna may include a plurality of antenna elements corresponding to one transmission path (or reception path). As an example, the array antenna may include 256 antenna elements configured as 16 x 16. However, an embodiment of the present disclosure is not limited thereto, and the array antenna may include a plurality of antenna elements. For example, the array antenna may include 384 antenna elements configured as 16 x 24.

The RU 310 may include RF chains for processing a signal of each array antenna. The RF chains may be referred to as 'RFA'. The RFA may include RF components (e.g., a phase shifter and a power amplifier) for beamforming and a mixer. The mixer of the RFA may be configured to down-convert an RF signal of an RF frequency to an intermediate frequency or up-convert a signal of the intermediate frequency to a signal of the RF frequency. According to an embodiment, one set of RF chains may correspond to one array antenna. As an example, the RU 310 may include four RF chain sets for four array antennas. A plurality of RF chains may be connected to a transmission path or a reception path through a divider (e.g., 1:16). Although not illustrated in FIG. 3A, according to an embodiment, the RF chains may be implemented as a radio frequency integrated circuit (RFIC). The RFIC may process and generate RF signals supplied to a plurality of antenna elements. In terms of processing the RF signals, the RF chains may be referred to as RF processing circuitry.

The RU 310 may include a digital analog front end (DAFE) and an 'RFB'. The DAFE may be configured to mutually convert a digital signal and an analog signal. For example, the RU 310 may include two DAFEs (DAFE #0 and DAFE #1). The DAFE may be configured, in a transmission path, to up-convert a digital signal (i.e., digital up converting (DUC)) and convert the up-converted signal into an analog signal (i.e., digital to analog converting (DAC)). The DAFE may be configured, in a reception path, to convert an analog signal into a digital signal (i.e., analog to digital converting (ADC)) and down-convert the digital signal (i.e., digital down converting (DDC)). For example, the RFB may include a mixer and a switch corresponding to the transmission path and the reception path. The mixer of the RFB may be configured to up-convert a baseband frequency to an intermediate frequency or down-convert a signal of the intermediate frequency to a signal of the baseband frequency. The switch of the RFB may be configured to select one of the transmission path and the reception path. As an example, the RU 310 may include two RFBs (e.g., RFB #0 and RFB #1).

The RU 310 may include a field programmable gate array (FPGA) operating as a controller. The FPGA may mean a semiconductor element including a designable logic element and programmable internal circuitry. It may perform communication with the DU 320 through Serial Peripheral Interface (SPI) communication.

The RU 310 may include an RF local oscillator (LO). The RF LO may be configured to supply a reference frequency for up-conversion or down-conversion. According to an embodiment, the RF LO may be configured to provide a frequency for up-conversion or down-conversion of the RFB. For example, the RF LO may supply the reference frequency to the RFB #0 and the RFB #1 through a 2-way divider. For example, the RF LO may be configured to provide a frequency for up-conversion or down-conversion of the RFA. For example, the RF LO may supply the reference frequency to each of the RFAs (eight for each RF chain, for each polarization group) through a 32-way divider.

Referring to FIG. 3B, the RU 310 may include a DAFE block 311, an IF up/down conversion unit 313, a beamformer 315, an array antenna 317, and a control block 319. The DAFE block 311 may convert a digital signal into an analog signal or convert an analog signal into a digital signal. The IF up/down conversion unit 313 may correspond to an RFB (e.g., the RFB of FIG. 3A). Based on the reference frequency supplied from the RF LO, the IF up/down conversion unit 313 may convert a signal of a baseband frequency into a signal of an IF frequency, or convert a signal of the IF frequency into a signal of the baseband frequency. The beamformer 315 may correspond to an RFA (e.g., the RFA of FIG. 3A). Based on the reference frequency supplied from the RF LO, the beamformer 315 may convert a signal of an RF frequency into a signal of an IF frequency, or convert a signal of the IF frequency into a signal of the RF frequency. The array antenna 317 may include a plurality of antenna elements. Each antenna element of the array antenna 317 may be configured to radiate a signal processed through the RFA. The array antenna 317 may be configured to perform beamforming according to a phase applied by the RFA. The control block 319 may control each block of the RU 310 to perform a command from the DU 320 and the above-described signal processing.

Although the base station 110 is illustrated as an example of the electronic device 200 in FIGS. 2A, 2B, 3A, and 3B, embodiments of the present disclosure are not limited to the base station 110. Embodiments of the present disclosure may be applied not only to a base station configured with a DU and an RU, but also to any electronic device for radiation of a wireless signal.

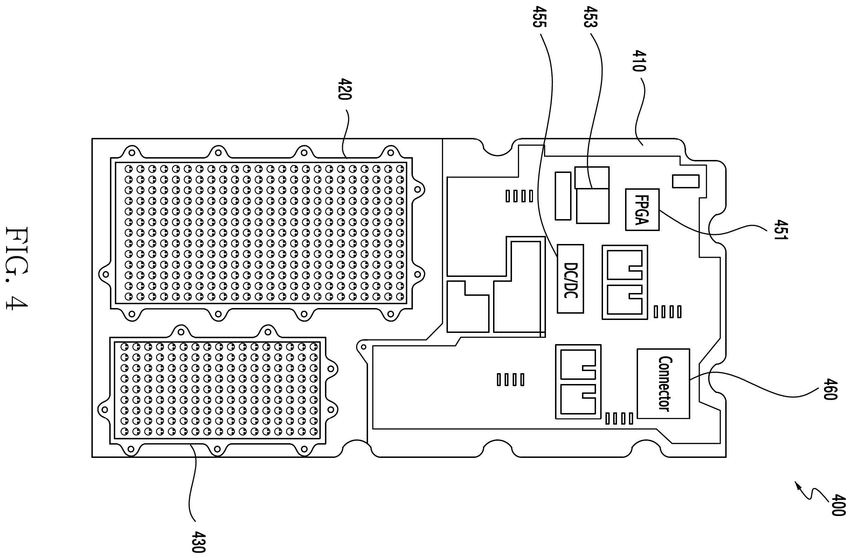

FIG. 4 illustrates an example of a radio module of an electronic device. For example, the radio module may include the RU module 210 of FIG. 2A. For example, the electronic device including the radio module may include a base station 110, a terminal 120, an electronic device 200, an AU 300, or an RU 310.

Referring to FIG. 4, an RU module 400 is illustrated as a radio module. The RU module 400 may include a board (hereinafter, a first board) (e.g., a PCB) on which antenna modules and components for signal processing (e.g., RF processing circuitry (e.g., an RFIC), a connector, a direct current (DC)/DC converter, and a DFE) are mounted. The RU module 400 may include a board (hereinafter, a second board) (e.g., a PCB or an FPCB) on which antennas of an antenna module are mounted. The first board may be referred to as an RU board, a main board, a main substrate, a power board, a mother board, a mother substrate, a package board, or a filter board. The second board may be referred to as an antenna board, an antenna substrate, a radiation substrate, a radiation board, or an RF board. Hereinafter, the first board is referred to and described as an RU board, and the second board is referred to and described as an antenna board, but a term having an equivalent technical meaning may be alternatively used.

The RU board 410 may include components for signal delivery to a radiator (e.g., an antenna). According to an embodiment, one or more second boards may be disposed on the RU board 410. The one or more second boards may include an antenna board 420 for a first frequency band (e.g., a frequency band including about 26 GHz and/or a frequency band including about 28 GHz) and at least one antenna board 430 for a second frequency band (e.g., a frequency band including about 39 GHz). As an example, the first frequency band may include an n258 band defined in 3GPP (which is a timed division duplex (TDD) band, and 24.25 GHz or more and less than 27.5 GHz) or an n257 band (which is a TDD band, and 26.5 GHz or more and less than 29.5 GHz). As an example, the second frequency band may include an n260 band defined in 3GPP (which is a TDD band, and 37 GHz or more and less than 40 GHz). The antenna board 420 may include at least one board (e.g., six boards arranged in 3x2) arranged on a plane (e.g., a surface of the RU board 410). The antenna board 430 may include at least one board (e.g., six boards arranged in 3x2) arranged on a plane (e.g., a surface of the RU board 410). One or more array antennas may be mounted on the RU board 410. For example, two array antennas may be mounted above the RU board 410. An array antenna for the first frequency band may be disposed in an area of the RU board 410. In addition, an array antenna for the second frequency band may be disposed in another area of the RU board 410.

In FIG. 4, two antenna modules and array antennas supporting two frequency bands are exemplified, but embodiments of the present disclosure are not limited thereto. Two array antennas may be disposed for each band in order to support a dual band, and the array antennas mounted on the RU board 410 may be configured to support 2-transmit 2-receive (2T2R).

The RU board 410 may include components for supplying an RF signal to an antenna. For example, the RU board 410 may include one or more radio frequency programmable gain amplifiers (FPGAs) 451. In addition, for example, the RU board 410 may include one or more local oscillators (LOs) 453. The LO 453 may be used to supply a reference frequency for up-conversion or down-conversion in an RF system. In addition, for example, the RU board 410 may include one or more DC/DC converters 455. The DC/DC converter 455 may be used to convert a direct current into a direct current. In addition, for example, the RU board 410 may include one or more connectors 460. The connector 460 may be used to deliver an electrical signal. The RU board 410 may further include various components for signal processing. For example, the RU board 410 may include one or more dividers. The divider may be used to distribute and deliver an input signal to multiple paths. In addition, for example, the RU board 410 may include one or more low dropout regulators (LDOs). The LDO may be used to suppress external noise and supply power. In addition, for example, the RU board 410 may include one or more voltage regulator modules (VRMs). The VRM may mean a module for ensuring that an appropriate voltage is maintained. In addition, for example, the RU board 410 may include one or more digital front ends (DFEs). In addition, for example, the RU board 410 may include one or more intermediate frequency (IF) processing units. In addition, for example, the RU board 410 may include an RF filter for filtering a signal.

FIG. 4 illustrates an exemplary disposition and configuration for the RU board 410, but, for another example, some configurations among the components illustrated in FIG. 4 may be omitted, or a larger number of components may be mounted.

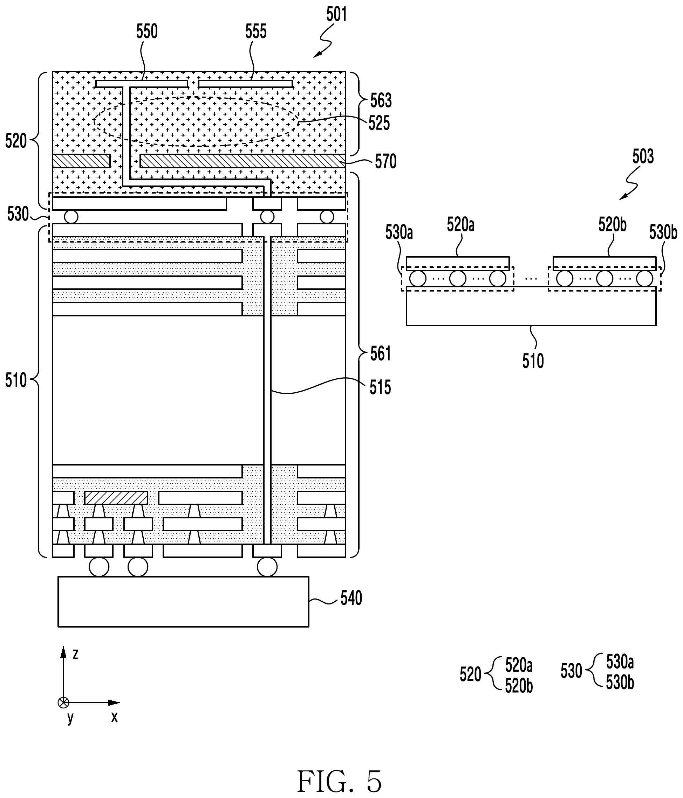

FIG. 5 illustrates an example of a radio module (e.g., an RU module 400) including a surface mounted device (SMD) type antenna. In order to increase development of communication technology, productivity, and/or design freedom, an SMD type antenna may be used. The SMD type antenna may be manufactured through a surface mounted technology (SMT) process. The SMD type antenna may include a board (e.g., an antenna board 420 or an antenna board 430) including a plurality of layers and radiators disposed in at least a portion of the plurality of layers. The SMD type antenna may be disposed above a surface of a board (e.g., a main board or an RU board 410). The SMD type antenna may be coupled to the board through a reflow process. For example, the SMD type antenna may be coupled to the main board through soldering. In a high-temperature reflow process, as solder elements melt, the SMD type antenna may be coupled to the main board.

Referring to FIG. 5, a radio module (e.g., the RU module 400) may include a first board 510, a second board 520, and a grid array 530. An example 501 represents a stacked structure including a path through which an RF signal provided from RF processing circuitry 540 is delivered to a radiator 550 of an antenna. In a direction (e.g., a (+)z-axis direction), the first board 510, the grid array 530, and the second board 520 may be stacked in this order.

The first board 510 may be electrically connected to components for processing and supplying an RF signal. For example, the components for processing and supplying the RF signal may be disposed above a surface of the first board 510. As an example, a surface of the first board 510 may be coupled to the RF processing circuitry 540. The first board 510 may include a plurality of layers (e.g., 16 layers). The first board 510 may include a feedline 515 formed across the plurality of layers. The feedline 515 indicates a signal line. The first board 510 may include a structure for ground. An RF signal processed through the RF processing circuitry 540 may be transmitted to the grid array 530 across the layers through the feedline 515. In order to describe a function and a disposition of the first board 510, the RU board 410 of FIG. 4 and the description of the RU board 410 may be referred to.

The second board 520 may include the radiator 550. The second board 520 may include a plurality of layers (e.g., six layers). The radiator 550 may be positioned in at least one layer among the plurality of layers. The second board 520, which is a component for an SMD type antenna, may include a wiring for delivering an RF signal to the radiator 550. Although an example in which the radiator 550 is disposed in the second board 520 is illustrated in FIG. 5, embodiments of the present disclosure are not limited thereto. For example, at least one radiator among radiators of the RU module 400 may be disposed above a surface of the second board 520. As a non-limiting example, in order to increase performance of radiation using the second board 520, not only the radiator 550 but also a resonator 555 may be disposed in the second board 520. In order to describe a function and a disposition of the second board 520, the antenna board 420 and the antenna board 430 of FIG. 4 and description thereof may be referred to.

The grid array 530 may be used to attach a board (e.g., the second board 520) of an SMD type antenna to a main board (e.g., the first board 510). For example, the grid array 530 may be disposed between the first board 510 and the second board 520. For example, the grid array 530 may be coupled to a first surface of the first board 510 and a first surface of the second board 520. When the first board 510, the grid array 530, and the second board 520 are stacked in this order in a direction (e.g., the (+)z-axis direction), the first surface of the first board 510 may face the direction, and a second surface of the second board 520 may face an opposite direction (e.g., a (-)z-axis direction) to the direction. The grid array 530 may be used to mount the second board 520 on a surface of the first board 510 (e.g., the first surface of the first board 510) through a reflow process. The grid array 530 may include a plurality of solder elements. For example, the grid array 530 may include a ball grid array (BGA). Each solder element may be a solder ball. For example, the grid array 530 may include a land grid array (LGA). Each solder element may be a land.

The second board 520 may be disposed above the first board 510 in a method illustrated in the example 501. Meanwhile, the example 501 is merely an example for describing a stacked structure, and the example 501 is not used as limiting other features of the radio module. For example, a size of the first surface of the first board 510 may be greater than a size of the first surface of the second board 520. A plurality of second boards may be disposed on the first surface of the first board 510. For example, as in an example 503, a second board-a 520a and a second board-b 520b may be disposed above the first board 510. The second board-a 520a may be understood as an example of the second board 520. The second board-b 520b may be understood as an example of the second board 520. The first surface of the first board 510 and a first surface of the second board-a 520a may be coupled through a first grid array 530a. The first surface of the first board 510 and a first surface of the second board-b 520b may be coupled through a second grid array 530b. According to an embodiment, the radio module (e.g., the RU module 400) may include a plurality of second boards (e.g., the second board 520) for a first frequency band (e.g., a frequency band including about 26 GHz). For example, the radio module may include 384 antenna elements. Each second board may include 64 antenna elements. The radio module may include six second boards. As an example, one antenna element may include a plurality of radiators (e.g., the radiator 550). For example, the antenna board 420 may include six second boards. For example, the antenna board 430 may include six second boards.

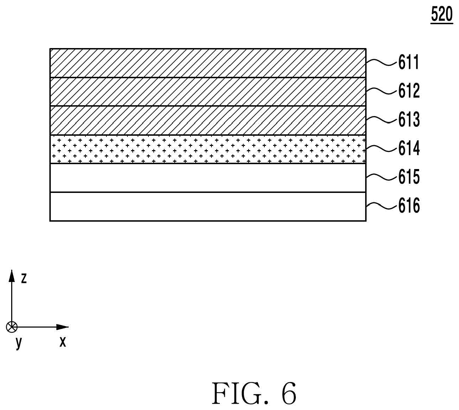

An RF signal supplied through the RF processing circuitry 540 may be provided to the second board 520 via the feedline 515. The second board 520 may deliver the RF signal to the radiator 550 through a feedline formed in a layer. At least one layer of the first board 510 and the second board 520 may be understood as a feeding unit 561. The radiator 550, the resonator 555, and at least one other layer for the radiator 550 in the second board 520 may be understood as a radiation unit 563. The second board 520 may include a ground layer 570. Based on a direction (e.g., the (+)z-axis direction), at least one layer disposed below the ground layer 570 may be included in the feeding unit 561. The at least one layer may be referred to as a lower layer of the second board 520. Based on a direction (e.g., the (+)z-axis direction), layers disposed above the ground layer 570 may be included in the radiation unit 563. The at least one layer may be referred to as an upper layer of the second board 520. A specific description of the second board 520 will be described through FIG. 6.

The first board 510 and the second board 520 may be coupled through the grid array 530. When bonding using the grid array 530, PCB warpage may occur. For example, the first board 510, the grid array 530, and the second board 520 may be bonded through a reflow process at a high temperature. For example, in the reflow process, solder elements of the grid array 530 start to melt at about 217°C, but bending of the second board 520 may start to bend from about 150°C. A solder element hardened first when a temperature decreases after high-temperature processing may interfere with bending recovery of the second board 520. More specifically, for example, a shape of the second board 520 may be a rectangle. It is confirmed that a degree of bending is increased in a corner area of the rectangle (e.g., an area adjacent to each vertex of the rectangle). Due to this, a crack of other solder elements may occur, or a problem in which at least one solder element is not coupled to both the first surface of the first board 510 and the first surface of the second board 520 may occur. In addition, upper layers of the second board 520 require fill-cut of an area 525 for a disposition of the radiator 550. Due to the fill-cut, a remained copper ratio of the upper layers of the second board 520 may be greater than a remained copper ratio of lower layers of the second board 520 by a certain level or more. As a difference between the remained copper ratio of the upper layers and the remained copper ratio of the lower layers increases, a degree of warpage of the second board 520 may increase in a process. Embodiments of the present disclosure provide a technology for reducing a warpage characteristic of a board (e.g., the first board 510) in coupling of the first board 510 and the second board 520 through the grid array 530 therebetween.

FIG. 6 illustrates an example of a second board (substrate) (e.g., a first board 520) where an antenna (e.g., a radiator 550) is disposed.

Referring to FIG. 6, the first board 520 may include a plurality of layers. For example, the first board 520 may include a first layer 611, a second layer 612, a third layer 613, a fourth layer 614, a fifth layer 615, and a sixth layer 616. The fourth layer 614 may include a ground portion. For example, the fourth layer 614 may be a ground board. The fourth layer 614 may be referred to as a ground layer in terms of providing ground. When a direction (e.g., a (+)z-axis direction) is assumed as an upward direction, a layer disposed above the fourth layer 614 may be referred to as an upper layer. The first board 520 may include three upper layers (e.g., the first layer 611, the second layer 612, and the third layer 613). When the direction (e.g., the (+)z-axis direction) is assumed as the upward direction, a layer disposed below the fourth layer 614 may be referred to as a lower layer. The second board 520 may include two lower layers (e.g., the fifth layer 615 and the sixth layer 616). For example, among the layers of the second board 520, the fifth layer 615 may include a feedline for RF signal delivery. In terms of a signal being fed, the fifth layer 615 may be referred to as a feeding layer. The lower layers may provide an RF signal delivered from the first board 510 to a radiator (e.g., the radiator 550) positioned in the upper layers. In a case that a signal is radiated in the direction, the radiator (e.g., the radiator 550) may be disposed in at least a portion of the upper layers of the second board 520. A space for mounting the radiator 550 may be required in at least a portion of the upper layers. For example, the second board 520 may include a fill-cut area where at least a portion of a copper foil area is removed. Due to the space, a copper ratio of the upper layers of the second board 520 may be lower than a copper ratio of the lower layers of the second board 520. A difference between the copper ratio of the upper layers and the copper ratio of the lower layers may cause warpage or bending of the second board 520 in a high-temperature process. Since a difference between a copper ratio of an upper area and a copper ratio of a lower area is clear based on the fourth layer 614, which is the ground layer, in the SMD type antenna, warpage of the second board 520 may occur more severely. In order to mitigate this problem, embodiments of the present disclosure provide a technology for reducing a warpage characteristic of a board (e.g., a first board 510) through a copper portion (or which may be referred to as a copper pattern, a copper foil pattern, or a copper foil portion) of the lower layers of the second board 520 in coupling of the first board 510 and the second board 520.

Although the second board 520 having a total of six layers is exemplified in FIG. 6, embodiments of the present disclosure are not limited thereto. Based on a ground layer, if it includes layers positioned in an upper portion and layers positioned in a lower portion, it may be understood as the second board 520 according to an embodiment of the present disclosure.

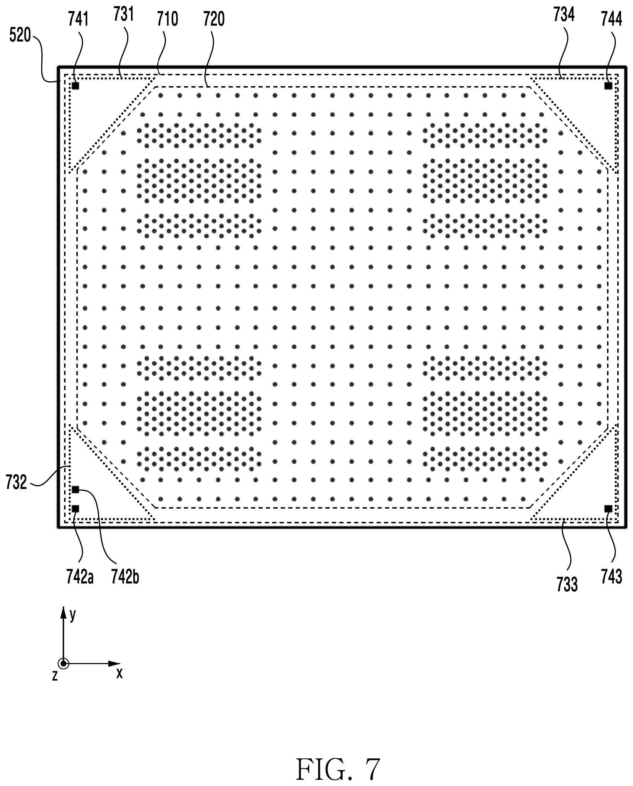

FIG. 7 illustrates an example of a first surface of a second board (e.g., a second board 520) where a ball grid array is disposed. A grid array 530 coupled to the second board 520 may include the ball grid array. The first surface of the second board 520 indicates a surface where the second board 520 of a radio module (e.g., an RU module 400) is coupled to a main board (e.g., a first board 510) through a grid array (e.g., the grid array 530). In FIG. 7, areas required to describe a disposition of balls of the ball grid array in the second board 520 may be defined.

Referring to FIG. 7, the first surface of the second board 520 may be coupled to the grid array 530. The first surface may include a board area 710 formed along a boundary of the first surface. The board area 710 may correspond to an entire area of the first surface. For example, the board area 710 may have a polygonal shape. As an example, the board area 710 may have a rectangular shape. Since a second surface of the second board 520 is a rectangle (or a square), the board area 710 may have a rectangular shape. The board area 710 of the first surface may include a connection area 720. The connection area 720 may indicate an area where solder elements of the grid array 530 are coupled. The board area 710 of the first surface may include at least one corner area. In the present disclosure, a corner area may indicate an area which includes a vertex of the board area 710 of the second board 520 and where any solder element is not coupled. For example, the board area 710 may include a first corner area 731 corresponding to a first vertex of a rectangle, a second corner area 732 corresponding to a second vertex of the rectangle, a third corner area 733 corresponding to a third vertex of the rectangle, and a fourth corner area 734 corresponding to a fourth vertex of the rectangle.

In being mounted over a first surface of the first board 510, the second board 520 may include a plurality of fiducial mark portions to be aligned on the first surface of the first board 510. For example, the second board 520 may include a first fiducial mark portion 741, a second fiducial mark portion 742a, an additional fiducial mark portion 742b, a third fiducial mark portion 743, and a fourth fiducial mark portion 744. The first fiducial mark portion 741 may be disposed in the first corner area 731. The second fiducial mark portion 742a may be disposed in the second corner area 732. In order to prevent reverse mounting of the second board 520, the additional fiducial mark portion 742b may be disposed in the second corner area 732. The third fiducial mark portion 743 may be disposed in the third corner area 733. The fourth fiducial mark portion 744 may be disposed in the fourth corner area 734.

The solder elements of the grid array 530 according to embodiments may be arranged only within the connection area 720, which is a portion of the board area 710, rather than the entire board area 710. In other words, solder elements may be coupled only to another area (e.g., the connection area 720) excluding corner areas (e.g., the first corner area 731, the second corner area 732, the third corner area 733, and the fourth corner area 734) among the board area 710. Assume a process of coupling the first board 510 and the second board 520 through the grid array 530. During a high-temperature process (e.g., a reflow process), the second board 520 may be bent. If a solder element is disposed in each corner area of the board area 710, when a temperature decreases after the high-temperature process, the solder element may interfere with bending recovery of the second board 520. Therefore, the grid array 530 according to embodiments of the present disclosure may include solder elements coupled only in an area (e.g., a connection area) excluding at least a portion (e.g., the first corner area 731, the second corner area 732, the third corner area 733, and the fourth corner area 734) among the board area 710.

Solder elements coupled to the second board 520 may not be disposed in a corner area (e.g., the first corner area 731, the second corner area 732, the third corner area 733, and the fourth corner area 734) among the board area 710. As a solder element is not disposed in the corner area, a certain relationship may be formed between a vertex of the board area 710 and the solder element. According to an embodiment, the solder elements may include a first solder element closest to a vertex of the board area 710 and a second solder element different from the first solder element. If the board area 710 is assumed as a two-dimensional plane (e.g., an xy plane), a distance between the vertex and the first solder element on a first axis (e.g., an x-axis) may be shorter than a distance between the vertex and the second solder element on the first axis (e.g., the x-axis). In contrast, a distance between the vertex and the first solder element on a second axis (e.g., a y-axis) substantially perpendicular to the first axis may be longer than a distance between the vertex and the second solder element on the second axis (e.g., the y-axis). This is because, as the connection area 720 has a shape different from the board area 710, solder elements are not disposed in a corner area corresponding to a vertex of the board area 710.

According to an embodiment, among the solder elements coupled to the second board 520, solder elements disposed on a boundary may be arranged to form an edge of a specified shape. The boundary indicates an outline of a closed figure including the solder elements. For example, solder elements forming the boundary may be arranged along an edge of a figure having a shape in which an area corresponding to a vertex is cut from a rectangular shape. As an example, the solder elements forming the boundary may correspond to an edge of an octagon. For example, the solder elements forming the boundary may include solder elements arranged in a direction different from a first direction (e.g., an x-axis) and a second direction (e.g., a y-axis) forming the board area 710 in a plane (e.g., an xy plane) of the board area 710. As an example, the connection area 720 may include solder elements arranged in a direction of about 45 degrees at a boundary adjacent to a corner area.

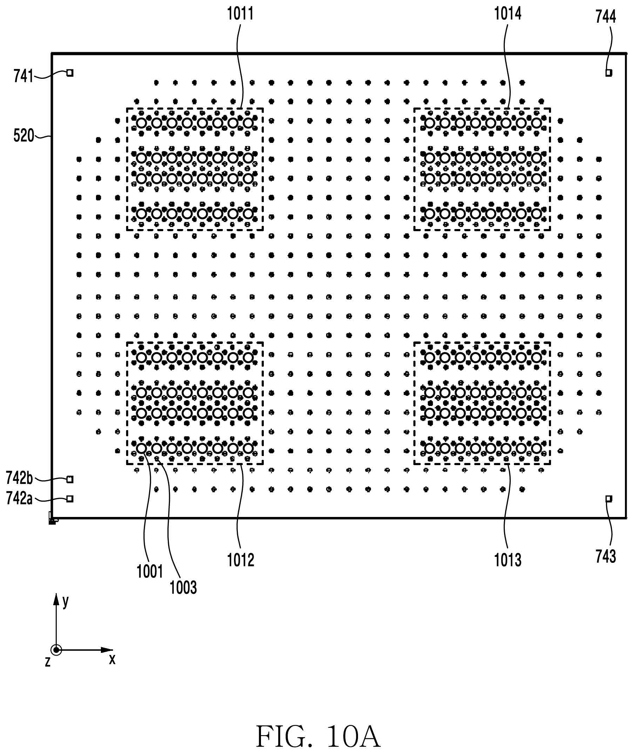

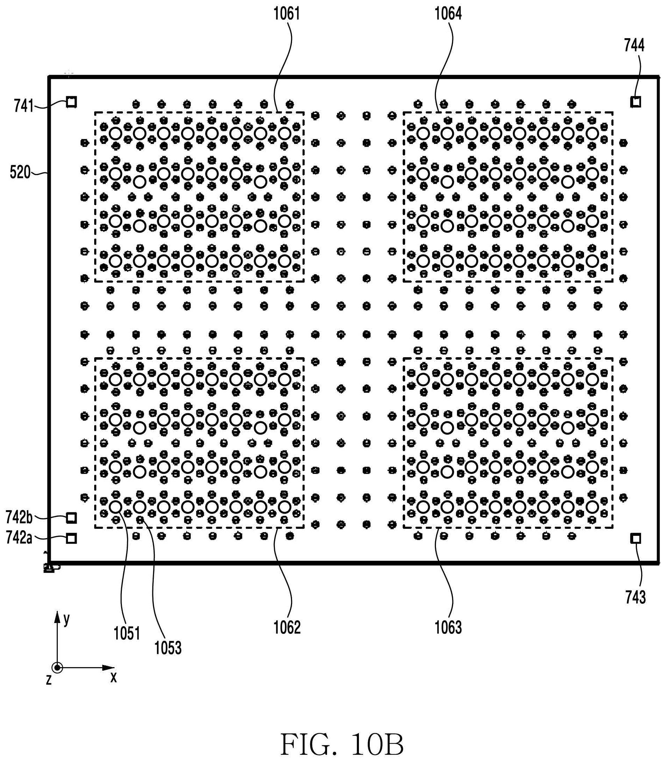

According to an embodiment, the solder elements coupled to the second board 520 may include solder elements for ground and solder elements for a signal line. The solder elements for the signal line may be used for feeding of an RF signal. The solder elements for the signal line may be electrically connected to a feedline (e.g., the feedline 515) in the stacked structure of the example 501 of FIG. 5. The solder elements for the signal line will be described in more detail in FIGS. 10A and 10B. In order to form a grid of the grid array 530, the solder elements for the ground may include solder elements arranged at regular intervals on an axis. For example, the solder elements may be arranged at regular intervals (hereinafter, a first interval) on the x-axis. For example, the solder elements may be arranged at regular intervals (hereinafter, a second interval) on the y-axis. The second interval may be the same as or different from the first interval. According to an embodiment, solder elements arranged on a boundary among the solder elements may include a solder element whose distance to a side of the second board (e.g., a side of a rectangle) is longer than the specified interval.

The connection area 720 according to embodiments of the present disclosure may correspond to a portion of the board area 710, rather than the entire board area 710. In other words, a portion (e.g., the first corner area 731, the second corner area 732, the third corner area 733, and the fourth corner area 734) among the board area 710 may not be coupled to solder elements (e.g., the solder elements for the signal line and the solder elements for the ground). Solder elements uniformly arranged in the connection area 720 (e.g., the solder elements for the ground) may no longer be uniformly arranged in the portion. In addition, if the solder elements for the signal line are disposed in a portion (e.g., the first corner area 731, the second corner area 732, the third corner area 733, and the fourth corner area 734) among the board area 710, feeding performance is affected due to bending, and thus the solder elements for the signal may not be disposed in the portion. For example, among the solder elements coupled to the second board 520, solder elements forming a boundary may include a first solder element. For example, among the solder elements coupled to the second board 520, based on a direction (e.g., a (+)y-axis), a solder element positioned next to the first solder element may not exist. In other words, based on the direction, the first solder element may be a solder element positioned at the outermost end. An interval between a second solder element adjacent to the first solder element based on an opposite direction (e.g., a (-)y-axis) to the direction and the first solder element may be referred to as a specified interval. In the direction, if a distance between the first solder element and the first surface of the second board 520 (or the board area 710) is longer than the specified interval, it may be confirmed that an empty area is positioned on the first surface of the second board 520. The empty area indicates a position included in an area (e.g., a corner area) where a disposition of a solder element is limited among positions where solder elements (e.g., the solder elements for the ground) may be disposed when considering the specified interval. A corner area according to an embodiment may include one or more empty areas.

As the number of the solder elements coupled to the second board 520 decreases, a degree of warpage of the second board 520 may decrease. However, if the number of the solder elements is excessively small, it may cause a problem in performance of a ground line or a signal line. As the number of the solder elements for the ground decreases, noise and/or interference is likely to be introduced into a delivered signal. Therefore, the grid array 530 may include solder elements arranged in consideration of the above-described trade-off. In order to reduce deterioration due to warpage while maintaining performance at a certain level or more, the grid array 530 may include solder elements that are not disposed only in a specified area (e.g., a corner area) but are uniformly disposed in a remaining area (e.g., the connection area 720).

Although an example in which solder elements are not disposed in a corner area including a vertex has been described in FIG. 7, embodiments of the present disclosure are not limited thereto. Solder elements may not be disposed in either a corner area including a vertex or an area adjacent to a side of the rectangle of the board area 710. For example, assume that an interval between solder elements in the connection area 720 is a first length based on the first axis (e.g., the x-axis). A boundary of the board area 710 parallel to the second axis (e.g., the y-axis) perpendicular to the first axis may be a side of the rectangle. On the first axis, a distance between a solder element closest to the boundary (hereinafter, a boundary solder element) and the boundary may be longer than the first length. In other words, although a solder element may be disposed next to the boundary solder element according to the interval of the first length, due to limitation in a corner area, the solder element may not be coupled to the board area 710. For example, assume that an interval between the solder elements in the connection area 720 is a second length based on the second axis (e.g., the y-axis). A boundary of the board area 710 parallel to the first axis (e.g., the x-axis) perpendicular to the second axis may be a side of the rectangle. On the second axis, a distance between a solder element closest to the boundary (hereinafter, a boundary solder element) and the boundary may be longer than the second length. In other words, although a solder element may be disposed next to the boundary solder element according to the interval of the second length, due to limitation in a corner area, the solder element may not be coupled to the board area 710.

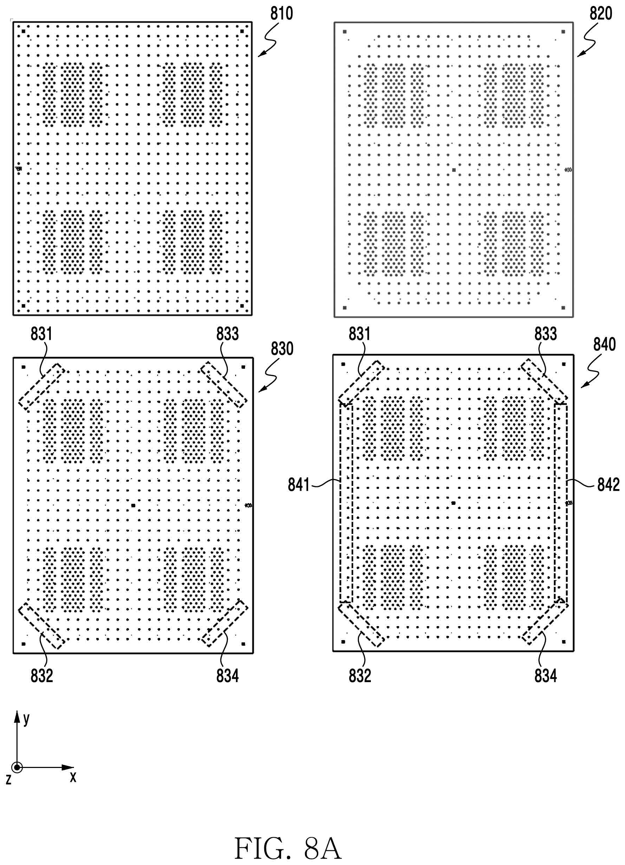

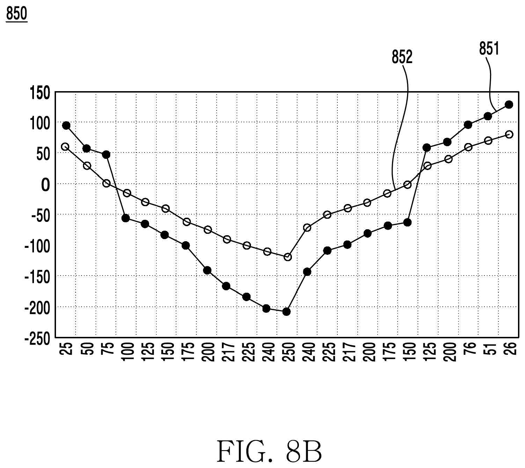

FIGS. 8A and 8B illustrate examples of a disposition of balls of a ball grid array. A grid array 530 coupled to a second board 520 may include the ball grid array. In FIGS. 8A and 8B, as an example of the second board 520, an antenna board 420 for a first frequency band (e.g., a frequency band including about 26 GHz and/or a frequency band including about 28 GHz) is described.

Referring to FIG. 8A, in a first disposition 810, a connection area 720 where balls of the grid array 530 are disposed may be a board area 710 of a first surface of the second board 520. For example, the connection area 720 may have a rectangular shape. The balls coupled within the connection area 720 may include balls for ground and balls for a signal line. As an example, the balls for the ground may include balls uniformly arranged within the connection area 720 (hereinafter, grid balls). Each grid ball corresponds to a ground ball.

In a second disposition 820, the connection area 720 where the balls of the grid array 530 are disposed may have a shape in which some balls (e.g., some of grid balls) are removed from the first disposition 810. For example, the second disposition 820 may indicate a shape in which balls adjacent to each vertex of a rectangle are removed from the first disposition 810. As balls disposed in a corner area are removed based on the first disposition 810, in the second disposition 820, no balls (e.g., the balls for the ground and the balls for the signal line) may be disposed in the corner area. For example, the connection area 720 may have an octagonal shape. The balls coupled within the connection area 720 may include the balls for the ground and the balls for the signal line. As an example, the balls for the ground may include grid balls uniformly arranged within the connection area 720.

In a third disposition 830, the connection area 720 where the balls of the grid array 530 are disposed may have a shape in which some balls (e.g., some of grid balls) are removed from the second disposition 820. For example, the third disposition 830 may indicate a shape in which balls disposed in a first portion 831, balls disposed in a second portion 832, balls disposed in a third portion 833, and balls disposed in a fourth portion 834 are removed. For example, the connection area 720 may have an octagonal shape. The balls coupled within the connection area 720 may include the balls for the ground and the balls for the signal line. As an example, the balls for the ground may include grid balls arranged within the connection area 720.

In a fourth disposition 840, the connection area 720 where the balls of the grid array 530 are disposed may have a shape in which some balls (e.g., some of grid balls) are removed from the third disposition 830. For example, the fourth disposition 840 may indicate a shape in which balls disposed in a fifth portion 841 and balls disposed in a sixth portion 842 are removed. For example, the connection area 720 may have an octagonal shape. The balls coupled within the connection area 720 may include the balls for the ground and the balls for the signal line. As an example, the balls for the ground may include grid balls uniformly arranged within the connection area 720.

Referring to FIG. 8B, a graph 850 indicates a degree of warpage for each temperature of the second board 520 having the third disposition 830. A horizontal axis of the graph 850 indicates a temperature (unit: Celsius, °C) at which a reflow process is performed. A vertical axis of the graph 850 indicates a warpage length (unit: um) of the second board 520. A first line 851 indicates a degree of warpage for each temperature of the board area 710 in the third disposition 830. A second line 852 indicates a degree of warpage for each temperature of the connection area 720 in the third disposition 830. When a reference value is about -140 um, it may be confirmed that the connection area 720 where the balls of the third disposition 830 are disposed at about 250°C has a degree of warpage less than the reference value.

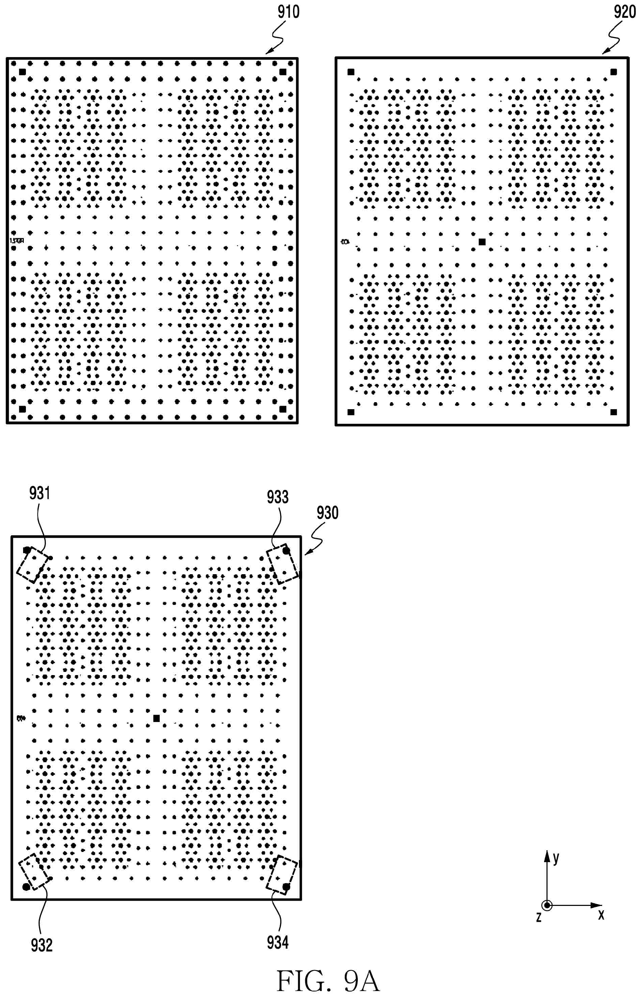

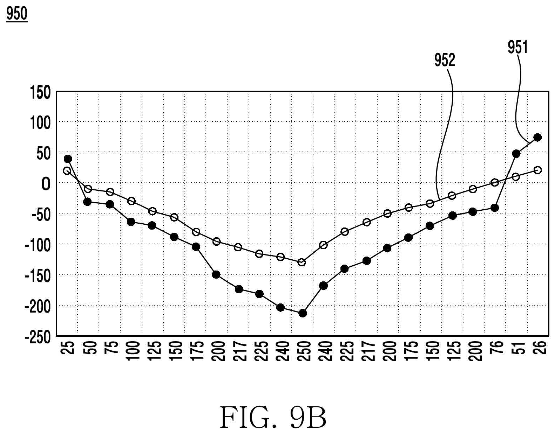

FIGS. 9A and 9B illustrate other examples of a disposition of balls of a ball grid array. A grid array 530 coupled to a second board 520 may include the ball grid array. In FIGS. 9A and 9B, as an example of the second board 520, at least an antenna board 430 for a second frequency band (e.g., a frequency band including about 39 GHz) is described.

Referring to FIG. 9A, in a first disposition 910, a connection area 720 where balls of the grid array 530 are disposed may be a board area 710 of a first surface of the second board 520. For example, the connection area 720 may have a rectangular shape. The balls coupled within the connection area 720 may include balls for ground and balls for a signal line. As an example, the balls for the ground may include balls uniformly arranged within the connection area 720 (hereinafter, grid balls).

In a second disposition 920, the connection area 720 where the balls of the grid array 530 are disposed may have a shape in which some balls (e.g., some of grid balls) are removed from the first disposition 910. For example, the second disposition 920 may indicate a shape in which balls forming a boundary (or balls arranged along the board area 710) among the balls of the first disposition 910 are removed. As balls positioned at a periphery are removed based on the first disposition 910, no balls (e.g., the balls for the ground and the balls for the signal line) may be disposed in a corner area of the second disposition 920. For example, the connection area 720 may have an octagonal shape. The balls may include the balls for the ground and the balls for the signal line. As an example, the balls for the ground may include grid balls uniformly arranged within the connection area 720.

In a third disposition 930, the connection area 720 where the balls of the grid array 530 are disposed may have a shape in which some balls (e.g., some of grid balls) are removed from the second disposition 920. For example, the third disposition 930 may indicate a shape in which balls disposed in a first portion 931, balls disposed in a second portion 932, balls disposed in a third portion 933, and balls disposed in a fourth portion 934 are removed. For example, the connection area 720 may have an octagonal shape. The balls may include the balls for the ground and the balls for the signal line. As an example, the balls for the ground may include the grid balls uniformly arranged within the connection area 720.

Referring to FIG. 9B, a graph 950 indicates a degree of warpage for each temperature of the second board 520 having the third disposition 930. A horizontal axis of the graph 950 indicates a temperature (unit: Celsius, degree) at which a reflow process is performed. A vertical axis of the graph 950 indicates a warpage length (unit: um) of the second board 520. A first line 951 indicates a degree of warpage for each temperature of the board area 710 in the third disposition 930. A second line 952 indicates a degree of warpage for each temperature of the connection area 720 in the third disposition 930. When a reference value is about -140 um, it may be identified that the connection area 720 where the balls of the third disposition 930 are disposed at about 250°C has a degree of warpage less than the reference value.

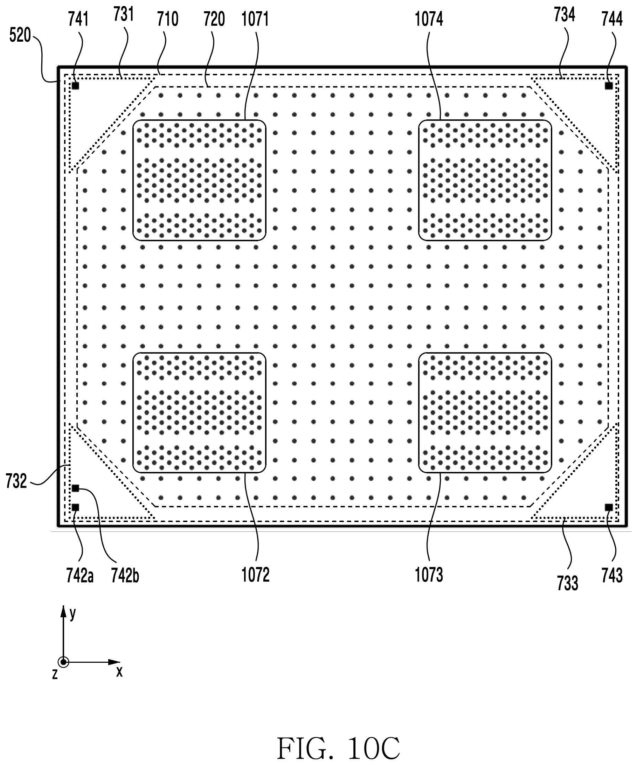

FIGS. 10A, 10B, and 10C illustrate examples of a signal line and a ground line of a ball grid array. A grid array 530 coupled to a second board 520 may include the ball grid array. In FIG. 10A, as an example of the second board 520, an antenna board 420 for a first frequency band (e.g., a frequency band including about 26 GHz and/or a frequency band including about 28 GHz) is described. In FIG. 10B, as an example of the second board 520, at least an antenna board 430 for a second frequency band (e.g., a frequency band including about 39 GHz) is described.

Referring to FIG. 10A, solder elements (e.g., balls) of the grid array 530 may be coupled to a first surface of the second board 520. When the second board 520 and a first board 510 are coupled through the grid array 530, the second board 520 may include a plurality of fiducial mark portions (e.g., a first fiducial mark portion 741, a second fiducial mark portion 742a, an additional fiducial mark portion 742b, a third fiducial mark portion 743, and a fourth fiducial mark portion 744) for alignment on a plane (e.g., an xy plane). For a fiducial mark portion, FIG. 7 and the descriptions of FIG. 7 may be referred to.

The solder elements (e.g., the balls) of the grid array 530 may include balls 1001 for a signal line and balls 1003 for ground. The balls 1001 for the signal line and the balls 1003 for the ground may be coupled to the first surface of the second board 520. The balls 1001 for the signal line may be disposed in a transmission area where a terminal (e.g., a signal pad) for feeding radiators of the second board 520 is positioned within a connection area 720. Herein, the transmission area indicates an area including balls corresponding to a signal line for delivery of an RF signal on the first surface of the second board 520. In order to deliver an RF signal of each RF processing circuitry to a radiator, balls for a signal line (e.g., the balls 1001 for the signal line) may be disposed in transmission areas (e.g., a first transmission area 1011, a second transmission area 1012, a third transmission delivery area 1013, and a fourth signal delivery area 1014) of the second board 520. The balls 1001 for the signal line may be disposed within the transmission areas. For example, the balls 1001 for the signal line may include first balls positioned in the first transmission area 1011, second balls positioned in the second transmission area 1012, third balls positioned in the third transmission area 1013, and fourth balls positioned in the fourth transmission area 1014. For example, the balls 1001 for the signal line may be classified into the first balls positioned in the first transmission area 1011, the second balls positioned in the second transmission area 1012, the third balls positioned in the third transmission area 1013, and the balls positioned in the fourth transmission area 1014.

Each ball of the balls 1001 for the signal line may contact a feedline (e.g., a feedline 555) of the first board 510 through a signal pad. As each ball is electrically connected to the feedline, an RF signal of the feedline may be provided to an antenna (e.g., a radiator 550) electrically connected to the corresponding ball. For example, the second board 520 may include 64 antenna elements. For the 64 antenna elements, four RF processing circuitries (e.g., first RF processing circuitry, second RF processing circuitry, third RF processing circuitry, and fourth RF processing circuitry) may be electrically connected to the first board 510. Each RF processing circuitry may provide RF signals to 16 antenna elements. The first balls positioned in the first transmission area 1061 may be disposed to provide RF signals from the first RF processing circuitry to 16 first antenna elements. The second balls positioned in the second transmission area 1012 may be disposed to provide RF signals from the second RF processing circuitry to 16 second antenna elements different from the first antenna elements connected to the first balls. For example, the third balls positioned in the third transmission area 1013 may be disposed to provide RF signals from the third RF processing circuitry to 16 third antenna elements different from the first antenna elements and the second antenna elements. For example, the fourth balls positioned in the fourth transmission area 1014 may be disposed to provide RF signals from the fourth RF processing circuitry to 16 fourth antenna elements different from the first antenna elements, the second antenna elements, and the third antenna elements.

The solder elements (e.g., the balls) of the grid array 530 may include the balls 1003 for the ground. For example, the balls 1003 for the ground may be classified into balls disposed within each transmission area (hereinafter, ground line balls) and balls positioned outside each transmission area (hereinafter, grid balls). The ground line balls disposed within each transmission area, as a ground line for reducing noise and interference, may be arranged to surround each ball for a signal line. For example, the ground line balls may be disposed adjacent to the balls (e.g., the first balls, the second balls, the third balls, and the fourth balls) for the signal line. As an example, the ground line balls disposed within the transmission area and the grid balls positioned outside each transmission area may be periodically arranged. For example, the grid balls may be periodically disposed according to a first specified interval on a first axis (e.g., an x-axis). For example, the grid balls may be periodically disposed according to a second specified interval on a second axis (e.g., a y-axis). The second specified interval may be the same as or different from the first specified interval. A ball may not be coupled to a position (e.g., an empty area) corresponding to a specified interval (e.g., the first specified interval or the second specified interval) but outside the connection area 720. Due to limitation in a corner area, empty areas to which a ball (e.g., grid balls) is not coupled may be positioned within a board area 710. For example, balls positioned on a boundary among the grid balls may be disposed to have a shape identical or similar to a shape of an edge of the connection area 720 (e.g., an octagon).

Referring to FIG. 10B, the solder elements (e.g., the balls) of the grid array 530 may be coupled to the first surface of the second board 520. Extent of the second board 520 of FIG. 10B may be smaller than extent of the second board 520 of FIG. 10A. As extent of the board area 710 of the second board 520 is changed, a disposition of solder elements within the board area 710 may also be changed. For description of the same reference numerals, the descriptions of the components illustrated in previous drawings may be referred to.

The solder elements (e.g., balls) of the grid array 530 may include balls 1051 for a signal line and balls 1053 for ground. The balls 1051 for the signal line and the balls 1053 for the ground may be coupled to the first surface of the second board 520.

The balls 1051 for the signal line may be disposed in a transmission area where a terminal (e.g., signal pad) for feeding radiators of the second board 520 is positioned within the connection area 720. Herein, the transmission area indicates an area including balls corresponding to a signal line for delivery of an RF signal on the first surface of the second board 520. In order to deliver an RF signal of each RF processing circuitry to a radiator, balls for a signal line (e.g., the balls 1001 for the signal line) may be disposed in transmission areas (e.g., a first transmission area 1061, a second transmission area 1062, a third transmission delivery area 1063, and a fourth signal delivery area 1064) of the second board 520. The balls 1001 for the signal line may be disposed within the transmission areas. For example, the balls 1001 for the signal line may include first balls positioned in the first transmission area 1061, second balls positioned in the second transmission area 1062, third balls positioned in the third transmission area 1063, and fourth balls positioned in the fourth transmission area 1064. For example, the balls 1051 for the signal line may include the first balls positioned in the first transmission area 1061, the second balls positioned in the second transmission area 1062, the third balls positioned in the third transmission area 1063, and the fourth balls positioned in the fourth transmission area 1064.

Each ball of the balls 1001 for the signal line may contact a feedline (e.g., the feedline 555) of the first board 510 through a signal pad. As each ball of first balls 1061 is electrically connected to the feedline, an RF signal of the feedline may be provided to an antenna (e.g., the radiator 550) connected to the corresponding ball. For example, the second board 520 may include 64 antenna elements. For the 64 antenna elements, four RF processing circuitries (e.g., first RF processing circuitry, second RF processing circuitry, third RF processing circuitry, and fourth RF processing circuitry) may be electrically connected to the first board 510. Each RF processing circuitry may provide RF signals to 16 antenna elements. The first balls positioned in the first transmission area 1061 may be disposed to provide RF signals from the first RF processing circuitry to 16 first antenna elements. The second balls positioned in the second transmission area 1062 may be disposed to provide RF signals from the second RF processing circuitry to 16 second antenna elements different from the first antenna elements connected to the first balls. For example, the third balls positioned in the third transmission area 1063 may be disposed to provide RF signals from the third RF processing circuitry to 16 third antenna elements different from the first antenna elements and the second antenna elements. For example, the fourth balls positioned in the fourth transmission area 1064 may be disposed to provide RF signals from the fourth RF processing circuitry to 16 fourth antenna elements different from the first antenna elements, the second antenna elements, and the third antenna elements.

Referring to FIG. 10C, the first surface of the second board 520 may be coupled to the grid array 530. The first surface may include the board area 710 formed along a boundary of the first surface. The board area 710 may correspond to an entire area of the first surface. For example, the board area 710 may have a rectangular shape. The connection area 720 may indicate a closed area including a portion to which the solder elements (e.g., solder balls) of the grid array 530 are coupled. The solder elements may include solder elements for ground and solder elements for a signal line. For example, RF processing circuitries (e.g., RFICs) may be connected to the first board 510. In order to deliver an RF signal of each RF processing circuitry to a radiator, balls for a signal line (e.g., the balls 1001 for the signal line and the balls 1053 for the signal line) may be disposed in transmission areas (e.g., a first transmission area 1071, a second transmission area 1072, a third transmission delivery area 1073, and a fourth signal delivery area 1074) of the second board 520. Herein, the transmission area indicates an area including balls corresponding to a signal line for delivery of an RF signal on the first surface of the second board 520. At least a portion (e.g., ground line balls) of balls for a ground line (e.g., the balls 1003 for the ground line and the balls 1053 for the ground line), as a ground line of the signal line, may be disposed in the transmission areas of the second board 520. For example, the second board 520 may include 64 antenna elements. For the 64 antenna elements, four RF processing circuitries may be electrically connected to the first board 510. Each RF processing circuitry may provide RF signals to 16 antenna elements. The second board 520 may include four transmission areas. For example, the second board 520 may include the first transmission area 1071, the second transmission area 1072, the third transmission delivery area 1073, and the fourth signal delivery area 1074. Balls for a signal line and balls for ground may be disposed in each transmission area.

Within the connection area 710, in addition to each transmission area, the balls for the ground may be disposed. However, the balls for the signal line may be disposed only within a transmission area. When assuming the stacked structure exemplified in FIG. 5, in the first board 510, a position where RF processing circuitry (e.g., the RF processing circuitry 540) is coupled may correspond to a position of the solder element for the signal line. Since the first board 510 includes a feedline (e.g., a coaxial plated through hole (PTH)) for RF signal delivery in a z-axis direction, the position of the solder element for the signal line may correspond to the position where the RF processing circuitry 540 is coupled. For example, when an RU module 400 is viewed in a (-)z-axis direction, each transmission area may at least partially overlap RF processing circuitries. If 8 RF processing circuitries provide RF signals to 64 antenna elements instead of 4 RF processing circuitries providing RF signals to the 64 antenna elements, positions of transmission areas within the connection area 720 of the second board 520 may be changed. Since each transmission area is a position where the balls for the signal line are coupled, if at least one of the balls for the signal line is not bonded to a board due to bending or warpage of a PCB, a problem may occur in delivery performance of an RF signal. Therefore, a transmission area for electrical connection with RF processing circuitry may be required to be positioned in a portion spaced apart from a corner area. For example, the balls for the signal line (the balls 1001 for the signal line and the balls 1051 for the signal line) may be positioned to avoid each corner area in which no ball is designed to be positioned.

Although an example in which the balls for the ground (e.g., the grid balls) are disposed in addition to each transmission area within the connection area 720 is described in FIGS. 10A to 10C, embodiments of the present disclosure are not limited thereto. Other components (e.g., power circuitry, RF components (e.g., a converter, an FPGA, and a connector), and a wiring of input/output (I/O)) of the RU module 400 may be positioned in an area where a portion of the grid balls is positioned between the first board 510 and the second board 520, instead of the grid balls.

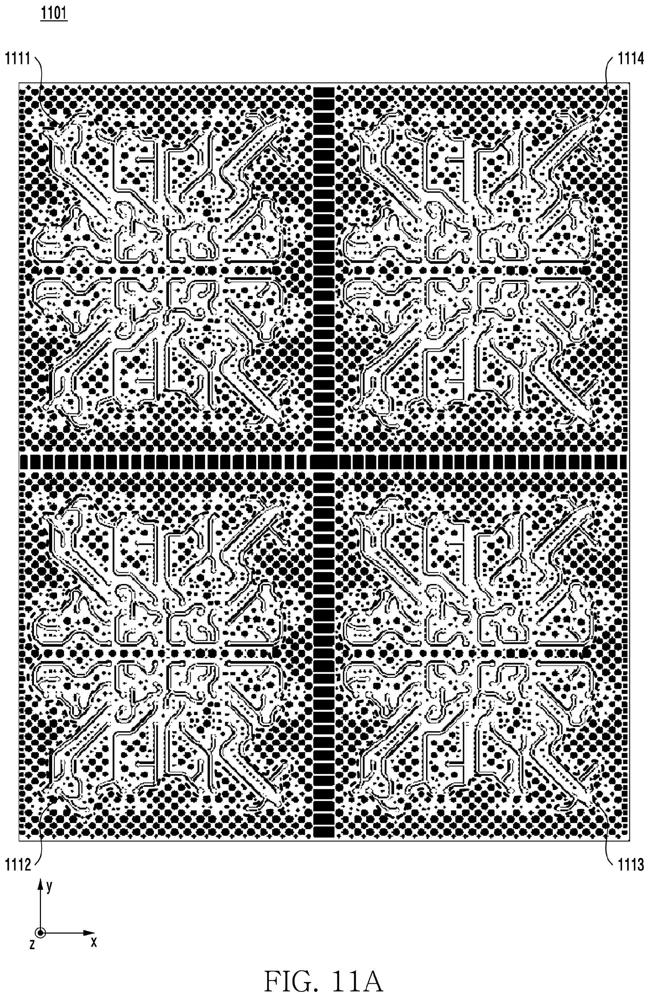

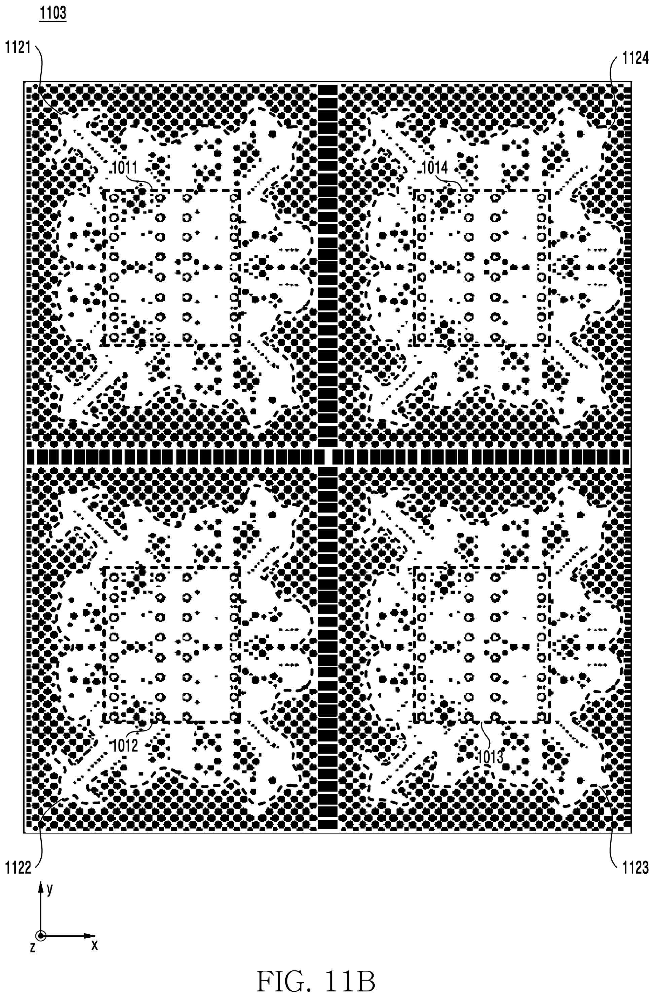

FIGS. 11A and 11B illustrate examples of a copper portion of a second board (e.g., a second board 520). In FIGS. 11A and 11B, as an example of the second board 520, an antenna board 420 for a first frequency band (e.g., a frequency band including about 26 GHz and/or a frequency band including about 28 GHz) is described. In order to implement an SMD type antenna, upper layers of the second board 520 may include a fill-cut area. Due to the fill-cut area, a copper ratio of the upper layers of the second board 520 may be lower than a copper ratio of lower layers of the second board 520. In order to reduce a difference between the copper ratio of the lower layers of the second board 520 and the copper ratio of the upper layers of the second board 520, the lower layers of the second board 520 may include a copper portion partially formed in each layer.

Referring to FIG. 11A, an example 1101 represents a copper portion of a fifth layer 615 among the lower layers of the second board 520. The copper portion may include a first portion 1111, a second portion 1112, a third portion 1113, and a fourth portion 1114. Signals provided through first balls coupled to a first transmission area 1011 among the balls 1001 for the signal line may be provided to a radiator through first feedlines of the fifth layer 615. For the first feedlines electrically connected to the first balls, the first portion 1111 may be formed in the fifth layer 615. Signals provided through second balls coupled to a second transmission area 1012 among the balls 1001 for the signal line may be provided to a radiator through second feedlines of the fifth layer 615. For the second feedlines electrically connected to the second balls, the second portion 1112 may be formed in the fifth layer 615. Signals provided through third balls coupled to a third transmission area 1013 among the balls 1001 for the signal line may be provided to a radiator through third feedlines of the fifth layer 615. For the third feedlines electrically connected to the third balls, the third portion 1113 may be formed in the fifth layer 615. Signals provided through fourth balls coupled to a fourth transmission area 1014 among the balls 1001 for the signal line may be provided to a radiator through fourth feedlines of the fifth layer 615. For the fourth feedlines electrically connected to the fourth balls, the fourth portion 1114 may be formed in the fifth layer 615.

Referring to FIG. 11B, an example 1103 represents a copper portion of a sixth layer 616 among the lower layers of the second board 520. The copper portion may include a first portion 1121, a second portion 1122, a third portion 1123, and a fourth portion 1124. Since the balls 1001 for the signal line are a structure to which RF signals are fed, the copper portion may be formed on a first surface of the second board 520 for electrical conductivity. For example, the first portion 1121 may include the first transmission area 1011 where balls for a signal line are disposed. The first portion 1121 may indicate a copper portion partially formed in the sixth layer 616 (e.g., a layer corresponding to a lower surface of the second board 520). According to an embodiment, a portion of the first portion 1121 may be partially disposed in an area (e.g., a first corner area 731) where solder elements (e.g., balls for ground) are not disposed. The first feedlines electrically connected to the signal line may be disposed in the fifth layer 615. In order to reduce loss and increase performance of signal delivery, the second board 520 may include a ground area positioned around each of the first feedlines. Since a fourth layer 614, which is a ground layer, is positioned at an upper end of each first feedline, a copper portion may be formed at a lower end of each first feedline. For example, even if copper portions are removed from the lower layers to reduce a remained copper ratio in the lower layers, a copper portion may exist in an area of the sixth layer 616 corresponding to an area of the first feedline of the fifth layer 615. For example, for feeding of an antenna element positioned in a corner (e.g., a corner in at least one of a first layer 611, a second layer 612, or a third layer 613) of the second board 520, the first feedline may be formed in a corner area of the fifth layer 615. The first portion 1121 of the sixth layer 616 may include the portion partially formed in the area (e.g., the first corner area 731) where the solder elements (e.g., the balls for the ground) are not disposed, for the first feedline.

The second portion 1122 may include the second transmission area 1012 where balls for a signal line are disposed. The second portion 1122 may indicate a copper portion partially formed in the sixth layer 616. According to an embodiment, a portion of the second portion 1122 may be partially disposed in an area (e.g., a second corner area 732) where solder elements (e.g., balls for ground) are not disposed. The second board 520 may include a ground area positioned around each of the second feedlines of the fifth layer 615. Since the fourth layer 614, which is the ground layer, is positioned at an upper end of each second feedline, a copper portion may be formed at a lower end of each second feedline. The second portion 1122 of the sixth layer 616 may include the portion partially formed in the area (e.g., the second corner area 732) where the solder elements (e.g., the balls for the ground) are not disposed, for the second feedline.

The third portion 1123 may include the third transmission area 1013 where balls for a signal line are disposed. The third portion 1123 may indicate a copper portion partially formed in the sixth layer 616. According to an embodiment, a portion of the third portion 1123 may be partially disposed in an area (e.g., a third corner area 733) where solder elements (e.g., balls for ground) are not disposed. The second board 520 may include a ground area positioned around each of the third feedlines of the fifth layer 615. Since the fourth layer 614, which is the ground layer, is positioned at an upper end of each third feedline, a copper portion may be formed at a lower end of each third feedline. The third portion 1123 of the sixth layer 616 may include the portion partially formed in the area (e.g., the third corner area 733) where the solder elements (e.g., the balls for the ground) are not disposed, for the third feedline.

The fourth portion 1124 may include the fourth transmission area 1014 where balls for a signal line are disposed. The fourth portion 1124 may indicate a copper portion partially formed in the sixth layer 616. According to an embodiment, a portion of the fourth portion 1124 may be partially disposed in an area (e.g., a fourth corner area 734) where solder elements (e.g., balls for ground) are not disposed. The second board 520 may include a ground area positioned around each of the fourth feedlines of the fifth layer 615. Since the fourth layer 614, which is the ground layer, is positioned at an upper end of each fourth feedline, a copper portion may be formed at a lower end of each fourth feedline. The fourth portion 1124 of the sixth layer 616 may include the portion partially formed in the area (e.g., the fourth corner area 734) where the solder elements (e.g., balls for ground) are not disposed, for the fourth feedline.

According to an embodiment, a difference between a remained copper ratio of the upper layers and a remained copper ratio of the lower layers may be less than or equal to a threshold value (e.g., about 40 % in a frequency band including about 26 GHz). For example, assume that the remained copper ratio of the upper layers is about 39.6 %. If an additional copper portion is not removed except for an area for feeding in the lower layers, the remained copper ratio of the lower layers may be about 86.2 %. At this time, the second board 520 may be bent by 307.4 um at a high temperature (e.g., about 245°C). Meanwhile, as a copper portion is removed from a certain portion in the lower layers, a copper portion is partially formed in an area (e.g., a corner area) where a solder element is not coupled, and thus the remained copper ratio of the lower layers may be about 76.4 %. At this time, the second board 520 may be bent by 214.3 um at a high temperature (e.g., about 245°C). It may be confirmed that an amount of bending of the second board 520 is reduced through the partially formed copper portion.

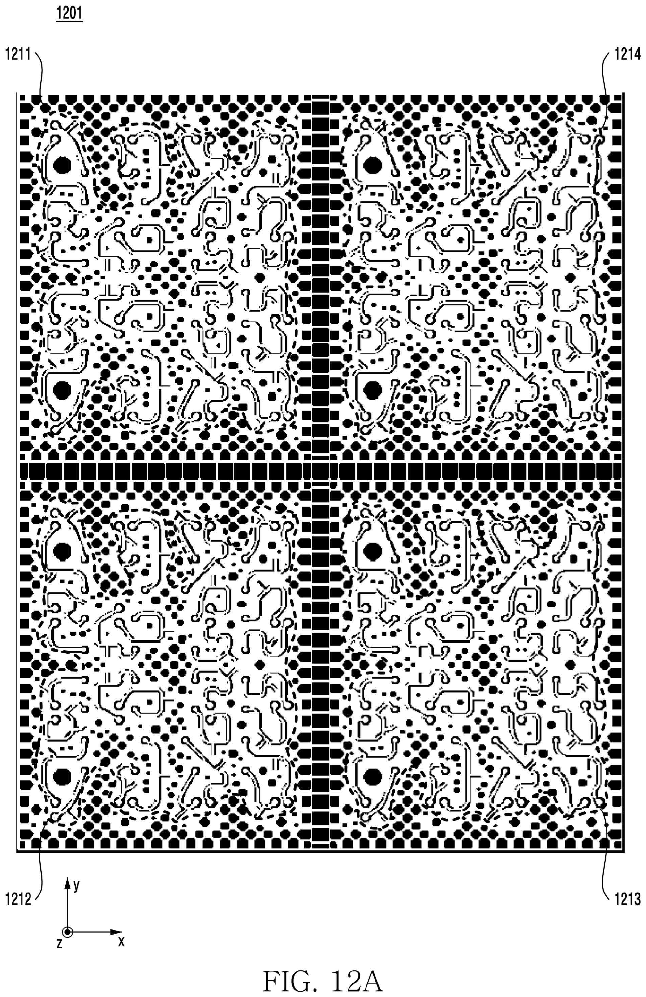

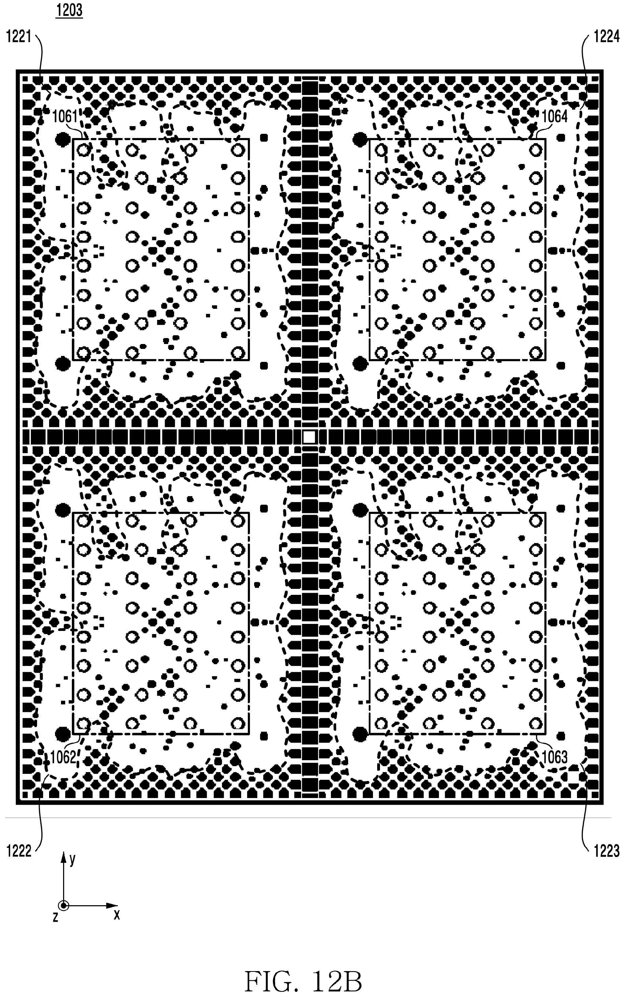

FIGS. 12A and 12B illustrate other examples of a copper portion of a second board (e.g., a second board 520). In FIGS. 12A and 12B, as an example of the second board 520, at least an antenna board 430 for a second frequency band (e.g., a frequency band including about 39 GHz) is described. In order to implement an SMD type antenna, upper layers of the second board 520 may include a fill-cut area. Due to the fill-cut area, a copper ratio of the upper layers of the second board 520 may be lower than a copper ratio of lower layers of the second board 520. In order to reduce a difference between the copper ratio of the lower layers of the second board 520 and the copper ratio of the upper layers of the second board 520, the lower layers of the second board 520 may include a copper portion partially formed in each layer.

Referring to FIG. 12A, an example 1201 represents a copper portion of a fifth layer 615 among the lower layers of the second board 520. The copper portion may include a first portion 1211, a second portion 1212, a third portion 1213, and a fourth portion 1214. Signals provided through first balls coupled to a first transmission area 1061 among the balls 1001 for the signal line may be provided to a radiator through first feedlines of the fifth layer 615. For the first feedlines electrically connected to the first balls, the first portion 1211 may be formed in the fifth layer 615. Signals provided through second balls coupled to a second transmission area 1062 among the balls 1001 for the signal line may be provided to a radiator through second feedlines of the fifth layer 615. For the second feedlines electrically connected to the second balls, the second portion 1212 may be formed in the fifth layer 615. Signals provided through third balls coupled to a third transmission area 1063 among the balls 1001 for the signal line may be provided to a radiator through third feedlines of the fifth layer 615. For the third feedlines electrically connected to the third balls, the third portion 1213 may be formed in the fifth layer 615. Signals provided through fourth balls coupled to a fourth transmission area 1064 among the balls 1001 for the signal line may be provided to a radiator through fourth feedlines of the fifth layer 615. For the fourth feedlines electrically connected to the fourth balls, the fourth portion 1214 may be formed in the fifth layer 615.

Referring to FIG. 12B, an example 1203 illustrates a copper portion of a sixth layer 616 among the lower layers of the second board 520. The copper portion may include a first portion 1221, a second portion 1222, a third portion 1223, and a fourth portion 1224. Since the balls 1001 for the signal line are a structure to which RF signals are fed, the copper portion may be formed on a first surface of the second board 520 for electrical conductivity. For example, the first portion 1221 may include the first transmission area 1061 where balls for a signal line are disposed. The first portion 1221 may indicate a copper portion partially formed in the sixth layer 616 (e.g., a layer corresponding to a lower surface of the second board 520). According to an embodiment, a portion of the first portion 1221 may be partially disposed in an area (e.g., a first corner area 731) where solder elements (e.g., balls for ground) are not disposed. The first feedlines electrically connected to the signal line may be disposed in the fifth layer 615. In order to reduce loss and increase performance of signal delivery, the second board 520 may include a ground area positioned around each of the first feedlines. Since a fourth layer 614, which is a ground layer, is positioned at an upper end of each first feedline, a copper portion may be formed at a lower end of each first feedline. For example, even if copper portions are removed from the lower layers to reduce a remained copper ratio in the lower layers, a copper portion may exist in an area of the sixth layer 616 corresponding to an area of the first feedline of the fifth layer 615. For example, for feeding of an antenna element positioned in a corner (e.g., a corner in at least one of a first layer 611, a second layer 612, or a third layer 613) of the second board 520, the first feedline may be formed in a corner area of the fifth layer 615. The copper portion of the sixth layer 616 may include the portion partially formed in the area (e.g., the first corner area 731) where the solder elements (e.g., the balls for the ground) are not disposed, for the first feedline.

The second portion 1222 may include the second transmission area 1062 where balls for a signal line are disposed. The second portion 1222 may indicate a copper portion partially formed in the sixth layer 616. According to an embodiment, a portion of the second portion 1222 may be partially disposed in an area (e.g., a second corner area 732) where solder elements (e.g., balls for ground) are not disposed. The second board 520 may include a ground area positioned around each of the second feedlines of the fifth layer 615. Since the fourth layer 614, which is the ground layer, is positioned at an upper end of each second feedline, a copper portion may be formed at a lower end of each second feedline. The second portion 1222 of the sixth layer 616 may include the portion partially formed in the area (e.g., the second corner area 732) where the solder elements (e.g., the balls for the ground) are not disposed, for the second feedline.

The third portion 1223 may include the third transmission area 1063 where balls for a signal line are disposed. The third portion 1223 may indicate a copper portion partially formed in the sixth layer 616. According to an embodiment, a portion of the third portion 1223 may be partially disposed in an area (e.g., a third corner area 733) where solder elements (e.g., balls for ground) are not disposed. The second board 520 may include a ground area positioned around each of the third feedlines of the fifth layer 615. Since the fourth layer 614, which is the ground layer, is positioned at an upper end of each third feedline, a copper portion may be formed at a lower end of each third feedline. The third portion 1223 of the sixth layer 616 may include the portion partially formed in the area (e.g., the third corner area 733) where the solder elements (e.g., the balls for the ground) are not disposed, for the third feedline.

The fourth portion 1224 may include the fourth transmission area 1064 where balls for a signal line are disposed. The fourth portion 1224 may indicate a copper portion partially formed in the sixth layer 616. According to an embodiment, a portion of the fourth portion 1224 may be partially disposed in an area (e.g., a fourth corner area 734) where solder elements (e.g., balls for ground) are not disposed. The second board 520 may include a ground area positioned around each of the fourth feedlines of the fifth layer 615. Since the fourth layer 614, which is the ground layer, is positioned at an upper end of each fourth feedline, a copper portion may be formed at a lower end of each fourth feedline. The fourth portion 1224 of the sixth layer 616 may include the portion partially formed in the area (e.g., the fourth corner area 734) where the solder elements (e.g., the balls for the ground) are not disposed, for the fourth feedline.

According to an embodiment, a difference between a remained copper ratio of the upper layers and a remained copper ratio of the lower layers may be less than or equal to a threshold value (e.g., about 45 % in a frequency band including about 39 GHz). For example, assume that the remained copper ratio of the upper layers is about 39.3 %. If an additional copper portion is not removed except for an area for feeding in the lower layers, the remained copper ratio of the lower layers may be about 88.3 %. At this time, the second board 520 may be bent by 171.6 um at a high temperature (e.g., about 245°C). Meanwhile, as a copper portion is removed from a certain portion in the lower layers, a copper portion is partially formed in an area (e.g., a corner area) where a solder element is not coupled, and thus the remained copper ratio of the lower layers may be about 78.8 %. At this time, the second board 520 may be bent by 149.6 um at a high temperature (e.g., about 245°C). It may be confirmed that an amount of bending of the second board 520 is reduced through the partially formed copper portion.

As described through FIGS. 11A, 11B, 12A, and 12B, based on a ground layer 570 (e.g., the fourth layer 614 of the second board 520), as a copper portion of the lower layers (e.g., the fifth layer 615 and the sixth layer 616) is partially formed rather than being formed across an entire layer, a deviation in a copper ratio between the upper layers (e.g., the first layer 611, the second layer 612, and the third layer 613) and the lower layers may decrease. Herein, being partially formed indicates that a copper portion does not exist in a partial area (e.g., a corner area). As a copper portion is removed from a layer, a copper ratio in the layer may be reduced. For efficient feeding performance, the partial area may be an area where solder elements are not disposed. A degree of warpage of the second board 520 may be mitigated through a copper portion partially formed in the area (e.g., the first corner area 731, the second corner area 732, the third corner area 733, or the fourth corner area 734) where the solder elements are not disposed.

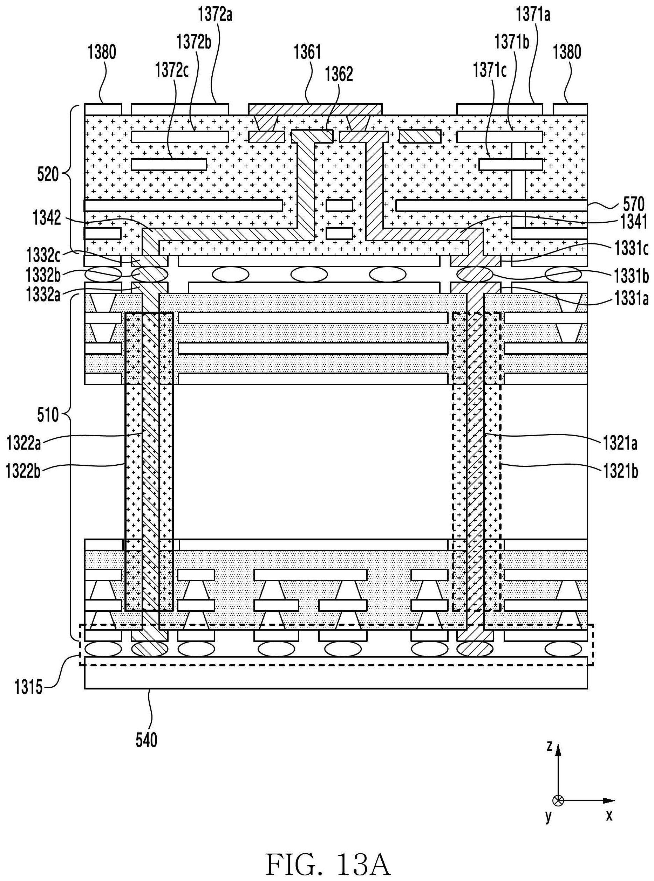

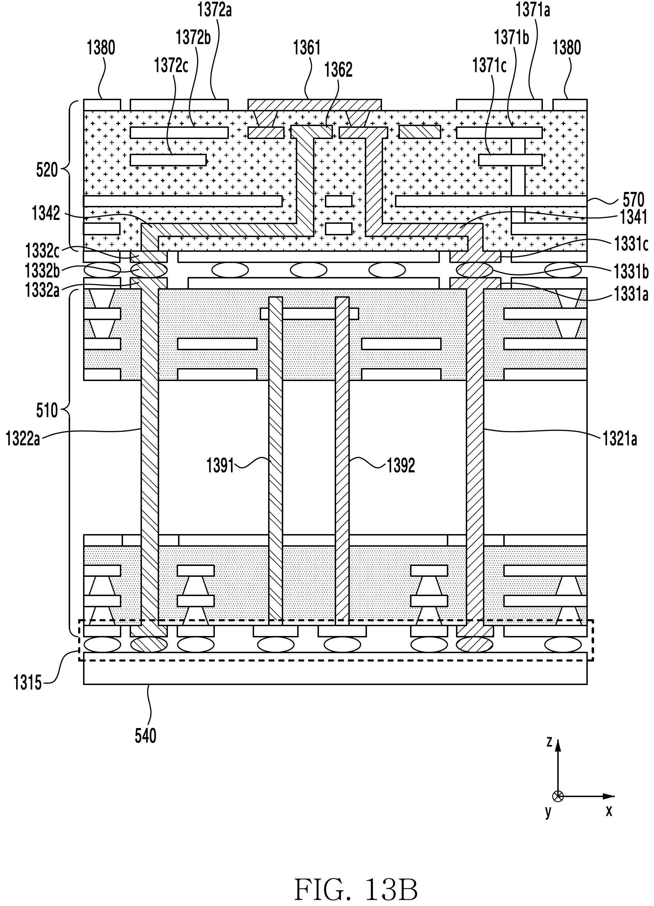

FIGS. 13A and 13B illustrate examples of a radio module (e.g., a radio module 400) including an SMD type antenna. Through the SMD type antenna, as a feedline is disposed in a layer (e.g., a fifth layer 615) of a second board 520, a manufacturing process of a first board 510 may be simplified. For example, the number of times of stacking of the first board 510 may be reduced. For a higher yield of the radio module using the SMD type antenna, the structure of the radio module described through FIGS. 5 to 12B is exemplified.

Referring to FIG. 13A, the radio module (e.g., the RU module 400) may include the first board 510, the second board 520, and a grid array 530. An example 501 represents a stacked structure including a path through which an RF signal provided from RF processing circuitry 540 is delivered to a radiator 550 of an antenna. In a direction (e.g., a (+)z-axis direction), the first board 510, the grid array 530, and the second board 520 may be stacked in this order. For the first board 510, the second board 520, and the grid array 530, the descriptions of FIG. 5 may be referred to.

The first board 510 may be electrically connected to components for processing and supplying an RF signal. For example, the components for processing and supplying the RF signal may be disposed over a surface of the first board 510. As an example, a surface of the first board 510 may be coupled to the RF processing circuitry 540. The first board 510 may include a plurality of layers (e.g., 16 layers). The first board 510 may include a feedline (e.g., a coaxial plated through hole (PTH)) formed across the plurality of layers. For example, the first board 510 may include a first coaxial PTH for a first polarization and a second coaxial PTH for a second polarization. The first coaxial PTH may include a first feedline 1321a for a signal line and a first plate portion 1321b. The first plate portion 1321b may be used as ground for signal transmission of the first feedline 1321a. The second coaxial PTH may include a second feedline 1322a for a signal line and a second plate portion 1322b. The second plate portion 1322b may be used as ground for signal transmission of the second feedline 1322a. The first polarization may be substantially perpendicular to the second polarization. For example, the first polarization may be a polarization of about 45 degrees, and the second polarization may be a polarization of about -45 degrees. For another example, the first polarization may be a vertical polarization, and the second polarization may be a horizontal polarization.

A first signal of the first polarization provided from the RF processing circuitry 540 may be provided to a signal pad 1331a through the first feedline 1321a of the first coaxial PTH. The first signal may be provided to the second board 520 through the signal pad 1331a, a solder ball 1331b, and a signal pad 1331b. The first signal may be provided to a first radiator 1361 through a feedline 1341 of the second board 520. As an example, the feedline 1341 may be disposed in a lower layer (e.g., the fifth layer 615) of the second board 520. The first radiator 1361 may be configured to radiate the first signal. For example, the first radiator 1361 may be disposed on a surface (e.g., a surface opposite to a coupled surface) of the second board 520. As an example, the first radiator 1361 may be disposed in a first layer 611 of the second board 520. A second signal of the second polarization provided from the RF processing circuitry 540 may be provided to a signal pad 1332a through the second feedline 1322a of the second coaxial PTH. The second signal may be provided to the second board 520 through the signal pad 1332a, a solder ball 1332b, and a signal pad 1332b. The second signal may be provided to a second radiator 1362 through a feedline 1342 of the second board 520. As an example, the feedline 1342 may be disposed in a lower layer (e.g., the fifth layer 615) of the second board 520. The second radiator 1362 may be configured to radiate the second signal. For example, the second radiator 1362 may be disposed in a layer different from the first radiator 1361. As an example, the second radiator 1362 may be disposed in a second layer 612 of the second board 520.

As a non-limiting example, the second board 520 may further include resonators as well as radiators (e.g., the first radiator 1361 and the second radiator 1362). For example, the second board 520 may include a first resonator 1371a, a second resonator 1371b, and a third resonator 1371c. The first resonator 1371a, the second resonator 1371b, and the third resonator 1371c may provide high radiation gain through coupling with the first radiator 1361, and may be disposed for isolation from adjacent antenna elements (e.g., the first radiator 1361 and the second radiator 1362 correspond to the same antenna element). For example, the second board 520 may include a fourth resonator 1372a, a fifth resonator 1372b, and a sixth resonator 1372c. The fourth resonator 1372a, the fifth resonator 1372b, and the sixth resonator 1372c may provide high radiation gain through coupling with the second radiator 1362 and may be disposed for isolation from adjacent antenna elements (e.g., the first radiator 1361 and the second radiator 1362 correspond to the same antenna element).

As a non-limiting example, the second board 520 may include a dummy pattern 1380. Due to a fill-cut area, a difference between a copper ratio of upper layers and a copper ratio of lower layers (hereinafter, a copper ratio deviation) may be high in the second board 520. Although a method for reducing the copper ratio deviation through etching of a copper portion of the lower layers has been described in FIGS. 11A, 11B, 12A, and 12B, the dummy pattern 1380 may be used to improve additional warpage performance. As the dummy pattern 1380 is positioned in at least a portion of the upper layers of the second board 520, the copper ratio of the upper layers may be increased. Through the second board 520 including not only the copper portion described through FIGS. 11A, 11B, 12A, and 12B but also the dummy pattern 1380, coupling between two boards of the radio module (e.g., the RU module 400) may be formed more robustly.

Referring to FIG. 13B, the radio module (e.g., the RU module 400) may include a first board 510, a second board 520, and a grid array 530. An example 501 represents a stacked structure including a path through which an RF signal provided from RF processing circuitry 540 is delivered to a radiator 550 of an antenna. In a direction (e.g., a (+)z-axis direction), the first board 510, the grid array 530, and the second board 520 may be stacked in this order. For the first board 510, the second board 520, and the grid array 530, the descriptions of FIG. 5 may be referred to. For other components, the descriptions of FIG. 13A may be referred to.

Since the second board 520 includes a feedline (e.g., a feedline 1341 or a feedline 1342) in the SMD type antenna, a manufacturing process of the first board 510 may be relatively simplified. For example, the number of times of stacking for manufacturing the first board 510 may be reduced. As the number of times of stacking is reduced, a disposition of a first coaxial PTH or a second coaxial PTH may not be easy. Therefore, the RU module 400 may include separate ground lines (e.g., a first ground line 1391 and a second ground line 1392) instead of the first plate portion 1321b and the second plate portion 1322b.

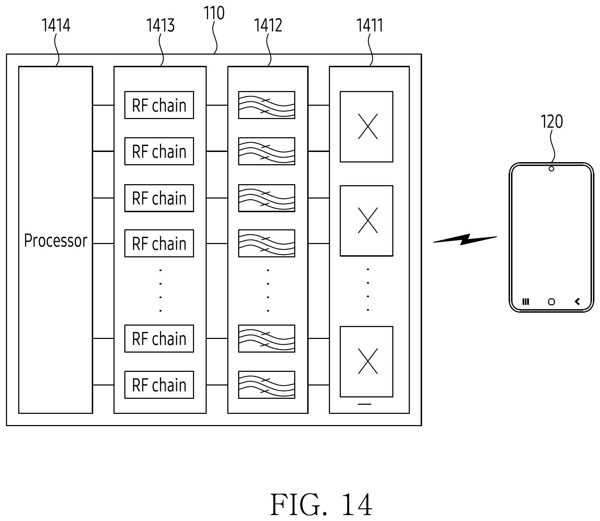

FIG. 14 illustrates an example of components of an electronic device including a radio module. For example, an electronic device 1410 may be a base station (e.g., a base station 110), a terminal (e.g., a terminal 120), an electronic device 200, and/or an AU 300. For example, the radio module may include an RU module 210, an RU 310, and/or an RU module 400. Not only the radio module mentioned through FIGS. 5 to 13B, but also an electronic device including the radio module is included in embodiments of the present disclosure.

Referring to FIG. 14, an exemplary functional configuration of the electronic device 1410 is illustrated. The electronic device 1410 may include an antenna unit 1411, a filter unit 1412, a radio frequency (RF) processing unit 1413, and a control unit 1414.

The antenna unit 1411 may include a plurality of antennas. An antenna performs functions for transmitting and receiving a signal through a wireless channel. The antenna may include a radiator formed of a conductor or a conductive pattern formed above a board (e.g., a second board 520, an antenna board, or an antenna substrate) or across at least one layer of the board. The antenna may radiate an up-converted signal on a wireless channel or obtain a signal radiated by another device. Each antenna may be referred to as an antenna element or an antenna device. The antenna unit 1411 may include an antenna array in which the plurality of antenna elements form an array. As a non-limiting example, the antenna array may also include sub arrays. The antenna unit 1411, which is an SMD type antenna, may include radiators of the antenna array and the board on which the radiators are disposed.

The antenna unit 1411 may be electrically connected to the filter unit 1412 through RF signal lines. The antenna unit 1411 may be mounted on an RU board (e.g., a first board 510 or a mother board). The RU board may include a plurality of RF signal lines connecting each antenna element and a filter of the filter unit 1412. These RF signal lines may be referred to as a feeding network. The antenna unit 1411 may provide a received signal to the filter unit 1412 or radiate a signal provided from the filter unit 1412 into the air. According to an embodiment, the antenna unit 1411 may include at least one antenna module having a dual-polarization antenna. The dual-polarization antenna may include antenna elements corresponding to different polarizations. For example, the dual-polarization antenna may include a first antenna element having a polarization of +45° and a second antenna element having a polarization of -45°. Of course, a polarization may be formed of other orthogonal polarizations in addition to +45° and -45°. Each antenna element may be connected to a feedline (feeding line) and electrically connected to the filter unit 1412, the RF processing unit 1413, and the control unit 1414 described below.

The filter unit 1412 may perform filtering to deliver a signal of a desired frequency. The filter unit 1412 may perform a function for selectively identifying a frequency by forming resonance. For example, the filter unit 1412 may structurally form the resonance through a cavity including a dielectric. For example, the filter unit 1412 may form the resonance through elements forming inductance or capacitance. For example, the filter unit 1412 may include an acoustic filter such as a bulk acoustic wave (BAW) filter or a surface acoustic wave (SAW) filter. The filter unit 1412 may include at least one of a band pass filter, a low pass filter, a high pass filter, or a band reject filter. The filter unit 1412 may include RF processing circuitries for obtaining a signal of a frequency band for transmission or a frequency band for reception. The filter unit 1412 according to various embodiments may electrically connect the antenna unit 1411 and the RF processing unit 1413.

The RF processing unit 1413 may include a plurality of RF paths. An RF path may be a unit of a path through which a signal received through an antenna or a signal radiated through an antenna passes. At least one RF path may be referred to as an RF chain. The RF chain may include a plurality of RF elements. The RF elements may include an amplifier, a mixer, an oscillator, a DAC, an ADC, and the like. For example, the RF processing unit 1413 may include an up converter that up-converts a digital transmission signal of a base band into a transmission frequency and a digital-to-analog converter (DAC) that converts the up-converted digital transmission signal into an analog RF transmission signal. The up converter and the DAC form a portion of a transmission path. The transmission path may further include a power amplifier (PA) or a coupler (or combiner). In addition, for example, the RF processing unit 1413 may include an analog-to-digital converter (ADC) that converts an analog RF reception signal into a digital reception signal and a down converter that converts the digital reception signal into a digital reception signal of a baseband. The ADC and the down converter form a portion of a reception path. The reception path may further include a low-noise amplifier (LNA) or a coupler (or divider). RF components of the RF processing unit may be implemented on a PCB. The electronic device 1410 may include a structure stacked in an order of the antenna unit 1411-the filter unit 1412-the RF processing unit 1413. The RF components of the RF processing unit and antennas may be implemented on a PCB, and filters may be repeatedly fastened between a PCB and a PCB to form a plurality of layers. An RFIC of the electronic device according to embodiments of the present disclosure may be included in the RF processing unit 1413.

The control unit 1414 may control overall operations of the electronic device 1410. The control unit 1414 may include various modules for performing communication. The control unit 1414 may include at least one processor, such as a modem. The control unit 1414 may include modules for digital signal processing. For example, the control unit 1414 may include a modem. When transmitting data, the control unit 1414 generates complex symbols by encoding and modulating a transmission bit string. In addition, for example, when receiving data, the control unit 1414 restores a reception bit string through demodulation and decoding of a baseband signal. The control unit 1414 may perform functions of a protocol stack required by a communication standard.

In FIG. 14, the functional configuration of the electronic device 1410 has been described. However, the example illustrated in FIG. 14 is merely an exemplary configuration of an electronic device including a radio module (e.g., the RU module 400 including the first board 510, the second board 520, and the grid array 530) according to embodiments of the present disclosure described through FIGS. 1 to 13B, and embodiments of the present disclosure are not limited to components illustrated in FIG. 14. Therefore, the radio module itself according to embodiments of the present disclosure, or at least a portion of communication equipment including the radio module may also be understood as an embodiment of the present disclosure.

In the present disclosure, a first frequency band (e.g., a frequency band including about 26 GHz and/or a frequency band including about 28 GHz) and/or a second frequency band (e.g., a frequency band including about 39 GHz) has been described as an example, but description of a specific frequency band is not interpreted as limiting other embodiments of the present disclosure. For example, the radio module described in the present disclosure may support RF communication in a 4 GHz band, a 6 GHz band, and/or a 13 GHz band.

In embodiments, a radio module of an electronic device to perform communication with a terminal is provided. The radio module may comprise a first board, radio frequency (RF) processing circuitry electrically connected to the first board, a second board including a plurality of layers, a plurality of radiators disposed in at least one first layer among the layers of the second board, and a grid array including a plurality of solder elements coupled to a first side of the first board and a first side of the second board. The first side of the second board may include a connection area where the plurality of solder elements are coupled and at least one corner area where any solder element is not coupled. The second board may include a copper portion disposed in at least one second layer different from the at least one first layer among the layers of the second board. The copper portion may include a portion partially formed within the at least one corner area.

According to an embodiment, the plurality of solder elements may include solder elements for ground and solder elements for a signal line. Solder elements arranged on a boundary among the solder elements for the ground may have a distance to a side of the second board longer than the specified interval. A solder element may be included.

According to an embodiment, the solder elements arranged on the boundary may include solder elements arranged in a direction different from a first direction of the first side of the second board and a second direction perpendicular to the first direction.

According to an embodiment, the solder elements arranged on the boundary may be disposed along an edge of an octagon.

According to an embodiment, the solder elements may include a first solder element closest to a vertex of the second board among the solder elements and a second solder element different from the first solder element. A distance between a second position of the second solder element and the vertex on a first axis may be shorter than a distance between a first position of the first solder element and the vertex on the first axis. A distance between the second position of the second solder element and the vertex on a second axis perpendicular to the first axis may be longer than a distance between the first position of the first solder element and the vertex on the second axis.

According to an embodiment, the RF processing circuitry may be coupled to a second side opposite to the first side of the first board. At least one of the radiators may be disposed on a second side opposite to the first side of the second board. The first side of the second board may include a fiducial mark portion disposed in each of the at least one corner area.

According to an embodiment, a remained copper ratio of the at least one first layer may be greater than a remained copper ratio of the at least one second layer. The radiators may be configured to transmit signals on a frequency band including 26 gigahertz (GHz). A difference between the remained copper ratio of the at least one first layer and the remained copper ratio of the at least one second layer may be less than about 40 %.

According to an embodiment, a remained copper ratio of the at least one first layer may be greater than a remained copper ratio of the at least one second layer. The radiators may be configured to transmit signals on a frequency band including 39 gigahertz (GHz). A difference between the remained copper ratio of the at least one first layer and the remained copper ratio of the at least one second layer may be less than about 45 %.

According to an embodiment, the second board may include the at least one first layer, the at least one second layer, and a ground layer disposed between the at least one first layer and the at least one second layer. A size of the first side of the second board may be smaller than a size of the first side of the first board.

According to an embodiment, each of the solder elements may include a first pad coupled to the first side of the first board, a second pad coupled to the first side of the second board, and a solder ball including the first pad and the second pad.

In embodiments, an electronic device to perform communication with a terminal is provided. The electronic device may comprise a first board, radio frequency (RF) processing circuitry electrically connected to the first board, a plurality of second boards, a plurality of radiators disposed in at least one first layer among layers of each of the second boards, and a grid array including a plurality of solder elements coupled to a first side of the first board and a first side of each of the plurality of second boards. The first side of each of the plurality of second boards may include a connection area where the plurality of solder elements are coupled and at least one corner area where any solder element is not coupled. Each of the plurality of second boards may include a copper portion disposed in at least one second layer different from the at least one first layer among the layers. The copper portion may include a portion partially formed within the at least one corner area.

According to an embodiment, the plurality of solder elements may include solder elements for ground and solder elements for a signal line. Solder elements arranged on a boundary among the solder elements for the ground may have a distance to a side of the second board longer than the specified interval. A solder element may be included.

According to an embodiment, the solder elements arranged on the boundary may include solder elements arranged in a direction different from a first direction of the first side of the second board and a second direction perpendicular to the first direction.

According to an embodiment, the solder elements arranged on the boundary may be disposed along an edge of an octagon.

According to an embodiment, the solder elements may include a first solder element closest to a vertex of a corresponding board among the solder elements and a second solder element different from the first solder element. A distance between a second position of the second solder element and the vertex on a first axis may be shorter than a distance between a first position of the first solder element and the vertex on the first axis. A distance between the second position of the second solder element and the vertex on a second axis perpendicular to the first axis may be longer than a distance between the first position of the first solder element and the vertex on the second axis.

According to an embodiment, the RF processing circuitry may be coupled to a second side opposite to the first side of the first board. At least one of the radiators may be disposed on a second side opposite to the first side of each of the plurality of second boards. The first side of the second board may include a fiducial mark portion disposed in each of the at least one corner area.

According to an embodiment, the plurality of second boards may include first antenna boards for a first frequency band and second antenna boards for a second frequency band higher than the first frequency band. A size of each board of the first antenna boards may be greater than a size of each board of the second antenna boards. For each of the first antenna boards, a remained copper ratio of the at least one first layer may be greater than a remained copper ratio of the at least one second layer. For each of the second antenna boards, a remained copper ratio of the at least one first layer may be greater than a remained copper ratio of the at least one second layer.

According to an embodiment, the first frequency band may include 26 gigahertz (GHz). The second frequency band may include 39 GHz. For each of the first antenna boards, a difference between a remained copper ratio of the at least one first layer and a remained copper ratio of the at least one second layer may be less than about 40 %. For each of the second antenna boards, a difference between the remained copper ratio of the at least one first layer and the remained copper ratio of the at least one second layer may be less than about 45 %.

According to an embodiment, each of the plurality of second boards may include the at least one first layer, the at least one second layer, and a ground layer disposed between the at least one first layer and the at least one second layer. A size of the first side of each of the plurality of second boards may be smaller than a size of the first side of the first board.

According to an embodiment, each of the solder elements may include a first pad coupled to the first side of the first board, a second pad coupled to the first side of the second board, and a solder ball including the first pad and the second pad.

In embodiments, a radio module of an electronic device to perform communication with a terminal is provided. The radio module may comprise a first board, radio frequency (RF) processing circuitry electrically connected to the first board, a second board including a plurality of layers, a plurality of radiators disposed in at least one layer among the layers of the second board, and a grid array including a plurality of solder elements coupled to a first side of the first board and a first side of the second board. The first side of the second board may include a connection area where the plurality of solder elements are coupled and at least one corner area where any solder element is not coupled. The second board may include a copper portion disposed in a layer, which corresponds to the first side of the second board and is different from the at least one layer, among the layers of the second board. The copper portion may include a portion partially formed within the at least one corner area.

According to an embodiment, the layers may include the at least one layer where the plurality of radiators are disposed, a ground layer, a feeding layer where a feedline is disposed, and the layer. The feeding layer may be disposed between the ground layer and the layer. The copper portion may be formed to include all areas on the layer, which correspond to a position of the feedline in the feeding layer.

According to an embodiment, the plurality of solder elements may include solder elements uniformly disposed at specified intervals within the connection area. Among the uniformly disposed solder elements, solder elements arranged on a boundary may include a solder element whose distance to a side of the second board is longer than the specified interval.

According to an embodiment, the radiators may be configured to transmit signals on a frequency band including 26 gigahertz (GHz). The layers may include upper layers including the at least one layer, lower layers, and a ground layer. A remained copper ratio of the upper layers may be greater than a remained copper ratio of the lower layers, and a difference between the remained copper ratio of the upper layers and the remained copper ratio of the lower layers may be less than about 40 %.

According to an embodiment, the radiators may be configured to transmit signals on a frequency band including 39 gigahertz (GHz). The layers may include upper layers including the at least one layer, lower layers, and a ground layer. A remained copper ratio of the upper layers may be greater than a remained copper ratio of the lower layers, and a difference between the remained copper ratio of the upper layers and the remained copper ratio of the lower layers may be less than about 45 %.

According to an embodiment, a size of the first side of the second board may be smaller than a size of the first side of the first board.

In embodiments, an electronic device to perform communication with a terminal is provided. The electronic device may comprise a first board, a plurality of radio frequency (RF) processing circuitries electrically connected to the first board, a plurality of second boards, a plurality of radiators disposed in at least one layer among layers of each of the second boards, and a grid array including a plurality of solder elements coupled to a first side of the first board and a first side of each of the plurality of second boards. The first side of each of the plurality of second boards may include a connection area where the plurality of solder elements are coupled and at least one corner area where any solder element is not coupled. Each of the plurality of second boards may include a copper portion disposed in a layer, which corresponds to the first side of the second board and is different from the at least one layer, among the layers. The copper portion may include a portion partially formed within the at least one corner area.

According to an embodiment, the layers may include the at least one layer where the plurality of radiators are disposed, a ground layer, a feeding layer where a feedline is disposed, and the layer. The feeding layer may be disposed between the ground layer and the layer. The copper portion may be formed to include all areas on the layer, which correspond to a position of the feedline in the feeding layer.

According to an embodiment, the plurality of solder elements may include solder elements uniformly disposed at specified intervals within the connection area. Among the uniformly disposed solder elements, solder elements arranged on a boundary may include a solder element whose distance to a side of the second board is longer than the specified interval.

According to an embodiment, the plurality of second boards may include first antenna boards for a first frequency band and second antenna boards for a second frequency band higher than the first frequency band. A size of each board of the first antenna boards may be greater than a size of each board of the second antenna boards. The first antenna boards may include first upper layers, a first ground layer, and first lower layers. The second antenna boards may include second upper layers, a second ground layer, and second lower layers. For each of the first antenna boards, a remained copper ratio of the first upper layers may be greater than a remained copper ratio of the first lower layers. For each of the second antenna boards, a remained copper ratio of the second upper layers may be greater than a remained copper ratio of the second lower layers.

According to an embodiment, the first frequency band may include 26 gigahertz (GHz). The second frequency band may include 39 GHz. For each of the first antenna boards, a difference between the remained copper ratio of the first upper layers and the remained copper ratio of the first lower layers may be less than about 40 %. For each of the second antenna boards, a difference between the remained copper ratio of the second upper layers and the remained copper ratio of the second lower layers may be less than about 45 %.

According to an embodiment, a size of the first side of each of the plurality of second boards may be smaller than a size of the first side of the first board.

For one or more embodiments, at least one of components described in one or more of the preceding drawings may be configured to perform one or more operations, techniques, processes, and/or methods as described in the present disclosure. For example, a processor (e.g., a baseband processor) described in the present disclosure in association with one or more of the preceding drawings may be configured to operate according to one or more examples described in the present disclosure. For another example, a circuit associated with user equipment (UE), a base station, a network element, or the like, as described above in association with one or more of the preceding drawings, may be configured to operate according to one or more examples described herein.

Any of the embodiments described above may be combined with any other embodiment (or a combination of embodiments) unless explicitly stated otherwise. The foregoing description of one or more implementations is provided for illustration and explanation, but is not intended to limit the scope of the embodiments or to be exhaustive to the precise forms disclosed. Modifications and variations are possible in light of the above teachings or may be obtained from practice of various embodiments.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. A radio module of an electronic device to perform communication with a terminal, the radio module comprising:
a first board;
radio frequency (RF) processing circuitry electrically connected to the first board;
a second board including a plurality of layers;
a plurality of radiators disposed in at least one layer among the layers of the second board; and
a grid array including a plurality of solder elements coupled to a first side of the first board and a first side of the second board,
wherein the first side of the second board includes a connection area where the plurality of solder elements are coupled and at least one corner area where any solder element is not coupled,
wherein the second board includes a copper portion disposed in a layer, which corresponds to the first side of the second board and is different from the at least one layer, among the layers of the second board, and
wherein the copper portion includes a portion partially formed within the at least one corner area.

2. The radio module of claim 1,
wherein the layers include the at least one layer where the plurality of radiators are disposed, a ground layer, a feeding layer where a feedline is disposed, and the layer,
wherein the feeding layer is disposed between the ground layer and the layer, and
wherein the copper portion is formed to include all areas on the layer, which correspond to a position of the feedline in the feeding layer.

3. The radio module of claim 1,
wherein the plurality of solder elements include solder elements uniformly disposed at specified intervals within the connection area, and
wherein, among the uniformly disposed solder elements, solder elements arranged on a boundary include a solder element whose distance to a side of the second board is longer than the specified interval.

4. The radio module of claim 3, wherein the solder elements arranged on the boundary include solder elements arranged in a direction different from a first direction of the first side of the second board and a second direction perpendicular to the first direction.

5. The radio module of claim 1,
wherein the solder elements include a first solder element closest to a vertex of the second board among the solder elements and a second solder element different from the first solder element, and
wherein a distance between a second position of the second solder element and the vertex on a first axis is shorter than a distance between a first position of the first solder element and the vertex on the first axis, and
wherein a distance between the second position of the second solder element and the vertex on a second axis perpendicular to the first axis is longer than a distance between the first position of the first solder element and the vertex on the second axis.

6. The radio module of claim 1,
wherein the RF processing circuitry is coupled to a second side of the first board opposite to the first side of the first board,
wherein at least one of the radiators is disposed on a second side of the second board opposite to the first side of the second board, and
wherein the first side of the second board includes a fiducial mark portion disposed in each of the at least one corner area.

7. The radio module of claim 1,
wherein the radiators are configured to transmit signals on a frequency band including 26 gigahertz (GHz),
wherein the layers include, upper layers including the at least one layer, lower layers, and a ground layer,
wherein a remained copper ratio of the upper layers is greater than a remained copper ratio of the lower layers, and
wherein a difference between the remained copper ratio of the upper layers and the remained copper ratio of the lower layers is less than about 40 %.

8. The radio module of claim 1,
wherein the radiators are configured to transmit signals on a frequency band including 39 gigahertz (GHz),
wherein the layers include, upper layers including the at least one layer, lower layers, and a ground layer,
wherein a remained copper ratio of the upper layers is greater than a remained copper ratio of the lower layers, and
wherein a difference between the remained copper ratio of the upper layers and the remained copper ratio of the lower layers is less than about 45 %.

9. The radio module of claim 1,
wherein a size of the first side of the second board is smaller than a size of the first side of the first board.

10. The radio module of claim 1,
wherein each of the solder elements includes a first pad coupled to the first side of the first board, a second pad coupled to the first side of the second board, and a solder ball including the first pad and the second pad.

11. An electronic device to perform communication with a terminal, the electronic device comprising:
a first board;
a plurality of radio frequency (RF) processing circuitries electrically connected to the first board;
a plurality of second boards;
a plurality of radiators disposed in at least one layer among layers of each of the second boards; and
a grid array including a plurality of solder elements coupled to a first side of the first board and a first side of each of the plurality of second boards,
wherein the first side of each of the plurality of second boards includes a connection area where the plurality of solder elements are coupled and at least one corner area where any solder element is not coupled,
wherein each of the plurality of second boards includes a copper portion disposed in a layer, which corresponds to the first side of the second board and is different from the at least one layer, among the layers of the second board, and
wherein the copper portion includes a portion partially formed within the at least one corner area.

12. The electronic device of claim 11,
wherein the layers include the at least one layer where the plurality of radiators are disposed, a ground layer, a feeding layer where a feedline is disposed, and the layer,
wherein the feeding layer is disposed between the ground layer and the layer, and
wherein the copper portion is formed to include all areas on the layer, which correspond to a position of the feedline in the feeding layer.

13. The electronic device of claim 11,
wherein the plurality of solder elements include solder elements uniformly disposed at specified intervals within the connection area, and
wherein, among the uniformly disposed solder elements, solder elements arranged on a boundary include a solder element whose distance to a side of the second board is longer than the specified interval.

14. The electronic device of claim 13, wherein the solder elements arranged on the boundary include solder elements arranged in a direction different from a first direction of the first side of the second board and a second direction perpendicular to the first direction.

15. The electronic device of claim 11,
wherein the solder elements include a first solder element closest to a vertex of a corresponding board among the solder elements and a second solder element different from the first solder element, and
wherein a distance between a second position of the second solder element and the vertex on a first axis is shorter than a distance between a first position of the first solder element and the vertex on the first axis, and
wherein a distance between the second position of the second solder element and the vertex on a second axis perpendicular to the first axis is longer than a distance between the first position of the first solder element and the vertex on the second axis.
